# EUROPEAN PATENT APPLICATION

(11) **EP 4 697 893 A1**
(43) Date of publication of application: **18.02.2026**
(21) Application number: 25163353.3
(22) Date of filing: 12.03.2025
(51) Int. Cl.: H10D 84/01, H10D 30/01, H10D 30/00, H10D 64/01, H10D 64/27, H10D 84/83, H10D 84/85, H10D 88/00

(54) **SEMICONDUCTOR DEVICE**

(30) Priority: 12.08.2024 KR 20240107424
(71) Applicant: Samsung Electronics Co., Ltd., Suwon-si, Gyeonggi-do 16677 (KR)
(72) Inventor: CHOI, Youngmoon, Suwon-si (KR); PARK, Sungil, Suwon-si (KR); PARK, Jae Hyun, Suwon-si (KR)
(74) Representative: Marks & Clerk LLP

(57) **Abstract**

A semiconductor device includes active patterns spaced apart from one another in a first direction and extending in a second direction different from the first direction; a lower channel pattern and a lower source/drain pattern on the active patterns, in which the lower channel pattern and the lower source/drain pattern are alternately arranged in the second direction; an upper channel pattern on the lower channel pattern, and an upper source/drain pattern on the lower source/drain pattern; a gate pattern on the active patterns and on the lower channel pattern and the upper channel pattern; and a gate inner spacer on the gate pattern, and between the lower source/drain pattern and the upper source/drain pattern.

## Description

### BACKGROUND

Semiconductors are materials belonging to an intermediate region between a conductor and an insulator, and refer to a material that conducts electricity under certain conditions. Various semiconductor devices for example, memory devices may be manufactured using these semiconductor materials. Such semiconductor devices may be used in various electronic devices.

As the electronics industry develops, the demands on the characteristics of semiconductor devices are increasing. For example, there is an increasing demand for high reliability, high speed, and/or multi-functionality in semiconductor devices. To meet these demanding characteristics, structures within semiconductor devices are becoming increasingly complicated and integrated.

### SUMMARY

In general, the present disclosure is directed toward a semiconductor device.

According to some implementations, the present disclosure is directed to a semiconductor device capable of forming a lower source/drain contact and a lower gate contact by self-alignment without an additional structure such as a place holder, preventing a gate pattern from being damaged when forming the lower source/drain contact, controlling lateral growth of the lower source/drain pattern and an upper source/drain pattern, preventing a height of a lower surface of the gate pattern from being recessed to reduce parasitic capacitance, simplifying a cutting process of the gate pattern, minimizing variation in threshold voltage (Vₜ) by protecting a work function metal of the gate pattern, and controlling and minimizing variation in the threshold voltage (Vₜ) between a lower gate structure and an upper gate structure of the gate pattern.

According to some implementations, the present disclosure is directed to a semiconductor device that includes an active pattern arranged spaced apart in a first direction and extending in a second direction different from the first direction; a lower channel pattern and a lower source/drain pattern located on the active pattern and alternately arranged in the second direction; an upper channel pattern located on the lower channel pattern, and an upper source/drain pattern located on the lower source/drain pattern; a gate pattern located on the active pattern and located on the lower channel pattern and the upper channel pattern; and a gate inner spacer located between the gate pattern, and the lower source/drain pattern and the upper source/drain pattern; wherein the gate inner spacer has an overlapping portion that is overlapped with the upper channel pattern and the lower channel pattern in a third direction perpendicular to the first direction and the second direction, and a non-overlapping portion that is not overlapped therewith in the third direction.

According to some implementations, the present disclosure is directed to a semiconductor device that includes an active pattern arranged spaced apart in a first direction and extending in a second direction different from the first direction; a lower channel pattern and a lower source/drain pattern located on the active pattern and alternately arranged in the second direction; an upper channel pattern located on the lower channel pattern, and an upper source/drain pattern located on the lower source/drain pattern; a gate pattern located on the active pattern and located on the lower channel pattern and the upper channel pattern; a lower source/drain contact located under the lower source/drain pattern and connected to the lower source/drain pattern; and a partition wall pattern disposed spaced apart in the first direction, extending across the gate pattern in the second direction, and alternately disposed with the active pattern in the first direction; wherein in a third direction perpendicular to the first and second directions, the partition wall pattern extends from a level lower than the upper surface of the lower source/drain contact to a level lower than the upper surface of the gate pattern.

According to some implementations, the present disclosure is directed to a semiconductor device that includes an active pattern arranged spaced apart in a first direction and extending in a second direction different from the first direction; a lower channel pattern and a lower source/drain pattern located on the active pattern and alternately arranged in the second direction; an upper channel pattern located on the lower channel pattern, and an upper source/drain pattern located on the lower source/drain pattern; a gate pattern located on the active pattern and located on the lower channel pattern and the upper channel pattern; a gate inner spacer located between the gate pattern, and the lower source/drain pattern and the upper source/drain pattern, and having an overlapping portion that is overlapped with the upper channel pattern and the lower channel pattern in a third direction perpendicular to the first direction and the second direction, and a non-overlapping portion that is not overlapped therewith in the third direction; and a partition wall pattern spaced apart in the first direction, extending in the second direction, and alternately arranged with the active pattern in the first direction; wherein both side surfaces in the first direction of the lower source/drain pattern and the upper source/drain pattern are surrounded by the partition wall pattern, and both side surfaces in the second direction of the lower source/drain pattern and the upper source/drain pattern are surrounded by the overlapping portion and the non-overlapping portion of the gate inner spacer.

According to some implementations, the present disclosure is directed to a semiconductor device that can form a lower source/drain contact and a lower gate contact by self-alignment without an additional structure, such as a place holder, can prevent a gate pattern from being damaged when forming the lower source/drain contact, can control lateral growth of the lower source/drain pattern and the upper source/drain pattern, can reduce parasitic capacitance by preventing the height of a lower surface of the gate pattern from being recessed, can simplify a cutting process of the gate pattern, can minimize variation in threshold voltage (Vₜ) by protecting the work function metal of the gate pattern, and can control and minimize variation in threshold voltage (Vₜ) between a lower gate structure and an upper gate structure of the gate pattern.

At least some of the above and other features of the invention are set out in the claims.

### BRIEF DESCRIPTION OF THE DRAWINGS

Example implementations will be more clearly understood from the following detailed description, taken in conjunction with the accompanying drawings.
FIG. 1 is a plan view illustrating an example of a semiconductor device according to some implementations.
FIG. 2 shows cross-sectional views taken along lines X1-X1' and X2-X2' of FIG. 1 according to some implementations.
FIG. 3 shows cross-sectional views taken along lines Y1-Y1', Y2-Y2', and Y3-Y3' of FIG. 1 according to some implementations.
FIG. 4 is a cross-sectional view showing an example of a semiconductor device according to some implementations, taken along line X1-X1' of FIG. 1.
FIGS. 5, 7, 9, 11, 13, 15, 17, 19, 21, 23, 25, 27, and 29 are cross-sectional views showing examples of a method for manufacturing a semiconductor device taken along line X1-X1' and X2-X2' of FIG. 1 according to some implementations.
FIGS. 6 and 8 are cross-sectional views showing examples of a method for manufacturing a semiconductor device taken along line Y1-Y1' of FIG. 1 according to some implementations.
FIGS. 10, 12, 14, 16, 18, 20, 22, 24, 26, 28, and 30 are cross-sectional views showing examples of a method for manufacturing a semiconductor device taken along lines Y1-Y1', Y2-Y2', and Y3-Y3' of FIG. 1 according to some implementations.

### DETAILED DESCRIPTION

Hereinafter, example implementations will be explained in detail with reference to the accompanying drawings.

In order to clearly explain the present disclosure, parts irrelevant to the explanation are omitted, and the same reference numerals are given to identical or similar components throughout the specification.

The size and thickness of each constituent element, as shown in the drawings, are randomly indicated for better understanding and ease of description, and the present disclosure is not necessarily limited to as shown. In the drawings, the thickness of layers, regions, etc., are exaggerated for clarity. In addition, in the drawings, for better understanding and ease of description, the thickness of some layers and areas is exaggerated.

It will be understood that when an element, such as a layer, film, region, or substrate, is referred to as being "on" another element, it can be directly on the other element or intervening elements may also be present. In contrast, when an element is referred to as being "directly on" another element, there are no intervening elements present. The word "on" or "above" means being disposed on or below the object portion, and does not necessarily mean being disposed on the upper side of the object portion based on a gravitational direction.

In addition, unless explicitly described to the contrary, the word "comprise," and variations, such as "comprises" or "comprising," will be understood to imply the inclusion of stated elements but not the exclusion of any other elements. In addition, in the present disclosure, the phrase "on a plane" means viewing a target portion from the top, and the phrase "on a cross-section" means viewing a cross-section formed by vertically cutting a target portion from the side. In addition, throughout the present disclosure, two directions parallel to and intersecting the upper surface of the substrate are defined as the first direction D1 and the second direction D2, respectively, and the direction perpendicular to the upper surface of the substrate is described as the third direction D3. For example, the first direction D1 and the second direction D2 may be perpendicular to each other.

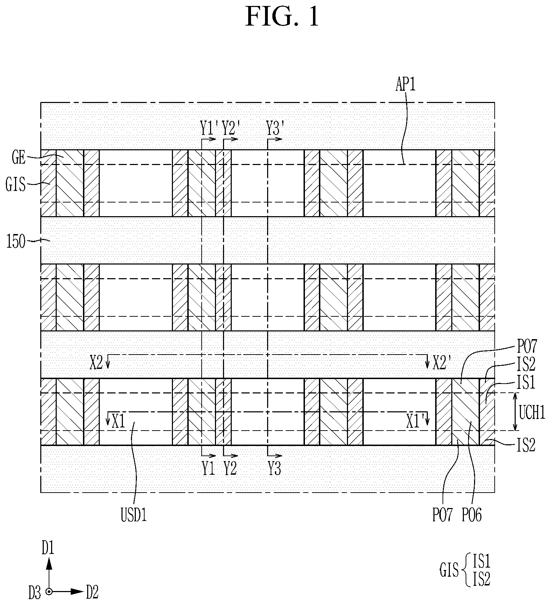

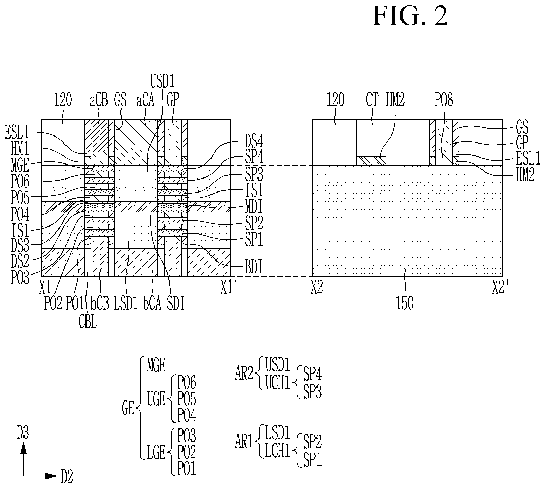

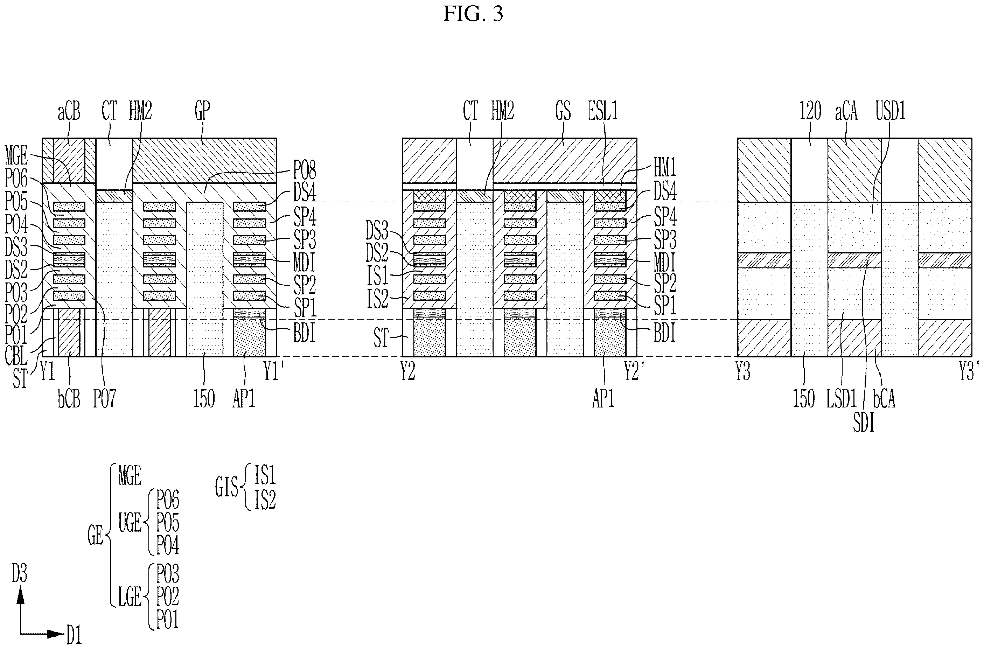

FIG. 1 is a plan view illustrating an example of a semiconductor device according to some implementations. FIG. 2 shows cross-sectional views taken along lines X1-X1' and X2-X2' of FIG. 1 according to some implementations. FIG. 3 shows cross-sectional views taken along lines Y1-Y1', Y2-Y2', and Y3-Y3' of FIG. 1 according to some implementations.

For clear understanding and simple illustration, FIG. 1 focuses on a cell region where logic cells constituting a logic circuit are arranged, and the illustration of a peripheral region arranged around the cell region is omitted. In addition, in FIG. 1, among the cell regions, an active pattern AP1, a gate pattern GE, a gate inner spacer GIS, an upper source/drain pattern USD1, and a partition wall pattern 150 are mainly illustrated.

For example, the semiconductor device may be a three-dimensional semiconductor device (e.g., a stacked transistor). In other words, transistors may be stacked in the third direction D3 in the cell region. For example, a single height cell (SHC) may be disposed between a first power wire and a second power wire, and the single height cell may include a first active region AR1 as a bottom tier, and a second active region AR2 may be stacked as a top tier on the first active region AR1.

For example, NMOSFETs in the first active region AR1 may be disposed, and PMOSFETs in the second active region AR2 may be stacked on the NMOSFETs. The first active region AR1 and the second active region AR2 may be spaced apart from each other in a third direction D3.

In other words, the three-dimensional semiconductor device may have a first active region AR1 and a second active region AR2 that overlap in a third direction D3. Accordingly, semiconductor devices may improve the degree of integration by reducing the area of the logic cell.

Meanwhile, in some implementations, a peripheral region may be located around the cell region, where transistors constituting a processor core or I/O terminals are arranged. In other words, the peripheral region may be a core/periphery region. As an example, the peripheral region may include a long-gate transistor (or long-channel transistor) having a relatively long gate length (i.e., channel length). Transistors in the peripheral region may operate at higher power than transistors in the cell region. For example, the transistors in the cell region may be single gate (SG) devices, and the transistors in the peripheral region may be extra gate (EG) devices.

An active pattern AP1 may be defined by a trench in the cell region. In other words, the active pattern AP1 may be a portion that protrudes vertically in the third direction D3. On a plane (e.g., FIG. 1), the active pattern AP1 may have a bar shape that is spaced apart in a first direction D1 and extends in a second direction D2. First and second active regions AR1 and AR2 may be sequentially stacked on the active pattern AP1. For example, the active pattern AP1 may include a semiconductor material, such as silicon, germanium, or silicon germanium, and may include, for example, silicon.

A device isolation layer ST may fill the trench between the active patterns AP1. For example, the device isolation layer ST may include silicon oxide. The upper surface of the device isolation layer ST may be coplanar with or lower than the upper surface of the active pattern AP1. The device isolation layer ST may not cover a lower channel pattern LCH1 and an upper channel pattern UCH1 described later.

A partition wall pattern 150 may be located between one active pattern AP1 and another active pattern AP1 adjacent to it in the first direction D1. The partition wall pattern 150 may extend parallel to the second direction D2 along the active pattern AP1. On a plane (e.g., FIG. 1), the partition wall pattern 150 may have a bar shape that is spaced apart in a first direction D1 and extends in a second direction D2.

For example, the partition wall pattern 150 may be alternately arranged with the active pattern AP1 in the first direction D1. The partition wall pattern 150 may be spaced apart from the active pattern AP1 in the first direction D1, and a device isolation layer ST may be located between partition wall pattern 150 and the active pattern AP1.

The partition wall pattern 150 may be a portion that protrudes vertically in the third direction D3. For example, the partition wall pattern 150 may extend in the third direction D3 from a level lower than the upper surface of a lower source/drain contact bCA described later to a level lower than the upper surface of a main gate structure MGE of the gate pattern GE described later.

Here, the level of the upper surface of the lower source/drain contact bCA may mean the shortest distance in the third direction D3 from the lower surface of the active pattern AP1 to the upper surface of the lower source/drain contact bCA. The level of the upper surface of the gate pattern GE may mean the shortest distance in the third direction D3 from the lower surface of the active pattern AP1 to the upper surface of the gate pattern GE.

For example, partition wall pattern 150 may extend from substantially the same level as the lower surface of the lower source/drain contact bCA or the lower surface of a lower gate contact bCB described later to substantially the same level as the upper surface of an upper gate structure UGE described later.

Accordingly, the partition wall pattern 150 may be located between one lower source/drain pattern LSD1 described later and another lower source/drain pattern LSD1 adjacent thereto in the first direction D1. The partition wall pattern 150 may be located between one upper source/drain pattern USD1 and another upper source/drain pattern USD1. The partition wall pattern 150 may be located between one lower gate structure LGE described later and another lower gate structure LGE adjacent thereto in the first direction D1. The partition wall pattern 150 may be located between one upper gate structure UGE described later and another upper gate structure UGE adjacent thereto in the first direction D1. The partition wall pattern 150 may be located between a lower source/drain contact bCA and another lower source/drain contact bCA adjacent thereto in the first direction D1. The partition wall pattern 150 may be located between a lower gate contact bCB in the first direction D1 and another lower gate contact bCB adjacent thereto in the first direction D1.

In other words, since the lower source/drain contact bCA and the lower gate contact bCB may be located between one partition wall pattern 150 and another partition wall pattern 150 adjacent thereto in the first direction D1, the lower source/drain contact bCA and the lower gate contact bCB may be formed by self-alignment without an additional structure, such as a place holder, and the gate pattern GE may be prevented from being damaged when the lower source/drain contact bCA is formed.

In addition, since the lower source/drain pattern LSD1 and the upper source/drain pattern USD1 may be located between one partition wall pattern 150 and another partition wall pattern 150 adjacent thereto in the first direction D1, the lower source/drain pattern LSD1 and the upper source/drain pattern USD1 may be laterally self-isolated by the partition wall pattern 150 in the first direction D1, thereby controlling the lateral growth of the lower source/drain pattern LSD1 and the upper source/drain pattern USD1.

In addition, one lower gate structure LGE of the gate pattern GE and an upper gate structure UGE located thereon may be separated from another lower gate structure LGE and an upper gate structure UGE located thereon, which are adjacent thereto in the first direction D1, by a partition wall pattern 150. In other words, partition wall pattern 150 may extend in the second direction D2 across the gate pattern GE, and partition wall pattern 150 may penetrate the lower gate structure LGE and the upper gate structure UGE of the gate pattern GE.

In addition, the connection of the main gate structure MGE may be cut by a gate cutting pattern CT described later located on the partition wall pattern 150, and only the main gate structure MGE may be connected by a main gate connection portion PO8 described later located on the partition wall pattern 150. Accordingly, since the gate pattern GE is extended or cut in the first direction D1 only on the partition wall pattern 150, the height of the lower surface of the extended portion of the gate pattern GE may be prevented from being recessed, thereby reducing parasitic capacitance, simplifying the cutting process of the gate pattern GE, and minimizing changes in threshold voltage (Vₜ) since the metal of the gate pattern GE is protected by the partition wall pattern 150.

For example, the partition wall pattern 150 may include an insulating material, and the insulating material may include SiON, SiCN, SiOCN, SiN, or a combination thereof, for example, may include SiOCN.

A second hardmask HM2 may be located on the partition wall pattern 150. Additionally, a gate cutting pattern CT may be located on the partition wall pattern 150. For example, a second hardmask HM2 may be located between the partition wall pattern 150 and the gate cutting pattern CT. In this case, the length of the second hardmask HM2 and the gate cutting pattern CT in the first direction D1 may be substantially the same as the length of the partition wall pattern 150 in the first direction D1. The length of the second hardmask HM2 and the gate cutting pattern CT in the second direction D2 may be greater than the length of the main gate structure MGE in the second direction D2 and may be substantially the same as the length of the upper channel pattern UCH1 described later in the second direction D2. Accordingly, the connection of the main gate structure MGE may be cut by the second hardmask HM2 and the gate cutting pattern CT located on the partition wall pattern 150.

For example, the level of the lower surface of the second hardmask HM2 may be lower than the level of the lower surface of the main gate structure MGE. In some implementations, the level of the lower surface of the second hardmask HM2 may be higher than the level of the lower surface of the main gate structure MGE. In some implementations, the level of the lower surface of the second hardmask HM2 may be substantially the same as the level of the lower surface of the main gate structure MGE. For example, the level of the upper surface of the second hardmask HM2 in the third direction D3 may be lower than the level of the upper surface of the main gate structure MGE in the third direction D3.

Additionally, the level of the lower surface of the gate cutting pattern CT may be higher than the level of the upper surface of the upper gate structure UGE and lower than the level of the upper surface of the main gate structure MGE. For example, the level of the upper surface of the gate cutting pattern CT may be higher than the level of the upper surface of the main gate structure MGE.

Here, the level of the lower surface or upper surface of the second hardmask HM2 may mean the shortest distance in the third direction D3 from the lower surface of the active pattern AP1 to the lower surface or upper surface of the second hardmask HM2.

Additionally, the level of the lower surface or upper surface of the gate cutting pattern CT may mean the shortest distance in the third direction D3 from the lower surface of the active pattern AP1 to the lower surface or upper surface of the gate cutting pattern CT.

When the main gate connection portion P08 is located on the partition wall pattern 150, a second hardmask HM2 may be located on each side of the main gate connection portion P08 in the second direction D2. At this time, the length of the second hardmask HM2 in the second direction D2 may be substantially the same as the length of a gate spacer GS in the second direction D2 described later.

For example, the second hardmask HM2 may include an insulating material, and the insulating material may include SiCN, SiOCN, SiN, or a combination thereof. The second hardmask HM2 may include multi-layers each including SiCN, SiOCN, SiN, or a combination thereof.

Additionally, the gate cutting pattern CT may include an insulating material, and the insulating material may include SiCN, SiOCN, SiN, or a combination thereof. The gate cutting pattern CT may include multi-layers each including SiCN, SiOCN, SiN, or a combination thereof.

A first active region AR1 including a lower channel pattern LCH1 and a lower source/drain pattern LSD1 may be located on the active pattern AP1. A lower channel pattern LCH1 may be interposed between one lower source/drain pattern LSD1 and another lower source/drain pattern LSD1 adjacent thereto in the second direction D2. A lower channel pattern LCH1 may connect a pair of lower source/drain patterns LSD1 to each other. For example, the lower channel pattern LCH1 and the lower source/drain pattern LSD1 may be alternately arranged in the second direction D2.

The lower channel pattern LCH1 may include a first semiconductor pattern SP1 and a second semiconductor pattern SP2 that are stacked and spaced apart from each other in a third direction D3. However, the present disclosure is not limited thereto, and the lower channel pattern LCH1 may include three or more semiconductor patterns. Each of the first semiconductor pattern SP1 and the second semiconductor pattern SP2 may include silicon (Si), germanium (Ge), or silicon germanium (SiGe). For example, each of the first semiconductor pattern SP1 and the second semiconductor pattern SP2 may include crystalline silicon.

A lower insulation structure BDI may be located between the active pattern AP1 and the lower channel pattern LCH1. For example, the lower insulation structure BDI may be located between the active pattern AP1 and the first semiconductor pattern SP1 located at the lowermost position in the lower channel pattern LCH1. Additionally, the lower insulation structure BDI may be located between the active pattern AP1 and a first sub-gate portion P01 located at the lowermost portion of the lower gate structure LGE described later.

The lower insulation structure BDI may separate the active pattern AP1 and the lower channel pattern LCH1 from each other in a third direction D3. The lower insulation structure BDI may be overlapped with the lower channel pattern LCH1 and the upper channel pattern UCH1 described later in the third direction D3. Additionally, the lower insulation structure BDI may be overlapped with an intermediate insulation structure MDI described later in a third direction D3. Additionally, the lower insulation structure BDI may be overlapped with the upper gate structure UGE and the lower gate structure LGE of the gate pattern GE, and an overlapping portion IS1 of the gate inner spacer GIS described later in the third direction D3. Meanwhile, the lower insulation structure BDI may not be overlapped with a sub-gate connection portion P07 of the gate pattern GE described later and a non-overlapping portion IS2 of the gate inner spacer GIS described later in the third direction D3.

For example, the lower insulation structure BDI may include an insulating material. For example, the lower insulation structure BDI may include silicon oxide, silicon nitride, or silicon oxynitride.

The gate pattern GE may be prevented from being damaged when forming a lower source/drain contact bCA by the lower insulation structure BDI, and the work function metal of the gate pattern GE may be protected, thereby minimizing changes in threshold voltage (Vₜ).

At least one dummy channel pattern may be interposed between the lower insulation structure BDI and the lower channel pattern LCH1, and the lower insulation structure BDI may be interposed between the dummy channel patterns. For example, a first dummy channel pattern may be located between the lower insulation structure BDI and the lower channel pattern LCH1.

For example, the first dummy channel pattern may be located between the lower insulation structure BDI and the first semiconductor pattern SP1 located at the lowermost portion of the lower channel pattern LCH1. Additionally, the first dummy channel pattern may be located between the active pattern AP1 and the first sub-gate portion PO1 located at the lowermost portion of the lower gate structure LGE.

In other words, the active pattern AP1, the lower insulation structure BDI, the first dummy channel pattern, the first sub-gate portion P01 of the lower gate structure LGE, and the first semiconductor pattern SP1 of the lower channel pattern LCH1 may be sequentially stacked in the third direction D3. The first dummy channel pattern may include a semiconductor material, such as silicon (Si), germanium (Ge), or silicon germanium (SiGe), or a silicon-based insulating material, such as silicon oxide or silicon nitride. For example, the first dummy channel pattern may include a silicon-based insulating material.

The lower source/drain pattern LSD1 may be located on the upper surface of the active pattern AP1. The lower source/drain pattern LSD1 may be an epitaxial pattern formed by a selective epitaxial growth (SEG) process. For example, the upper surface of the lower source/drain pattern LSD1 may be higher than the upper surface of the second semiconductor pattern SP2 of the lower channel pattern LCH1.

The lower source/drain pattern LSD1 may be doped with impurities to have a first conductivity type. The first conductivity type may be either N-type or P-type. For example, the first conductivity type may be N-type. The lower source/drain pattern LSD1 may include silicon (Si) or silicon germanium (SiGe).

In some implementations, the semiconductor device may further include a first interlayer insulation layer. The first interlayer insulation layer may be located on the side surface of the lower gate structure LGE and the upper surface of the lower source/drain pattern LSD1. For example, the first interlayer insulation layer may be located between the partition wall pattern 150 and the side surface of the lower gate structure LGE. For example, the first interlayer insulation layer may include silicon oxide (SiO₂), silicon nitride (SiN), silicon oxynitride (SiON), or a low-k material having a dielectric constant equal to or lower than silicon oxide.

In some implementations, a first interlayer stop layer may be further located between the lower gate structure LGE and the first interlayer insulation layer and between the lower source/drain pattern LSD1 and the first interlayer insulation layer. The first interlayer stop layer may include a material having an etch selectivity with respect to the first interlayer insulation layer. The first interlayer stop layer may include, for example, silicon nitride (SiN), silicon oxynitride (SiON), silicon oxycarbonitride (SiOCN), silicon boron nitride (SiBN), silicon oxyboron nitride (SiOBN), or silicon oxycarbide (SiOC).

A second active region AR2 may be located on the first active region AR1. The second active region AR2 may include an upper channel pattern UCH1 and an upper source/drain pattern USD1.

The upper channel pattern UCH1 may be located on the lower channel pattern LCH1. The upper source/drain pattern USD1 may be located on the lower source/drain pattern LSD1. In other words, the upper channel pattern UCH1 may be overlapped with the lower channel pattern LCH1 in the third direction D3. The upper source/drain pattern USD1 may be overlapped with the lower source/drain pattern LSD1 in the third direction D3. An upper channel pattern UCH1 may be interposed between one upper source/drain pattern USD1 and another upper source/drain pattern USD1 adjacent thereto in the second direction D2. The upper channel pattern UCH1 may connect a pair of upper source/drain patterns USD1 to each other. For example, the upper channel pattern UCH1 and the upper source/drain pattern USD1 may be alternately arranged in the second direction D2.

The upper channel pattern UCH1 may include a third semiconductor pattern SP3 and a fourth semiconductor pattern SP4 that are stacked and spaced apart from each other in the third direction D3. However, the present disclosure is not limited thereto, and the upper channel pattern UCH1 may include three or more semiconductor patterns. The third semiconductor pattern SP3 and the fourth semiconductor pattern SP4 of the upper channel pattern UCH1 may include the same semiconductor material as the first and second semiconductor patterns SP1 and SP2 of the lower channel pattern LCH1 described above.

An intermediate insulation structure MDI may be located between the lower channel pattern LCH1 and the upper channel pattern UCH1 thereon. For example, the intermediate insulation structure MDI may be located between the second semiconductor pattern SP2 located at the uppermost portion of the lower channel pattern LCH1 and the third semiconductor pattern SP3 located at the lowermost portion of the upper channel pattern UCH1. Additionally, the intermediate insulation structure MDI may be located between the third sub-gate portion P03 located at the uppermost portion in the lower gate structure LGE described later and the fourth sub-gate portion P04 located at the lowermost portion in the upper gate structure UGE described later.

The intermediate insulation structure MDI may separate the lower channel pattern LCH1 and the upper channel pattern UCH1 from each other in the third direction D3. The intermediate insulation structure MDI may be overlapped with the lower channel pattern LCH1 and the upper channel pattern UCH1 in the third direction D3. Additionally, the intermediate insulation structure MDI may be overlapped with the lower insulation structure BDI in a third direction D3.

Additionally, the intermediate insulation structure MDI may be overlapped with the upper gate structure UGE and the lower gate structure LGE of the gate pattern GE, and the overlapping portion IS1 of the gate inner spacer GIS in the third direction D3. Meanwhile, the intermediate insulation structure MDI may not be overlapped with the sub-gate connection portion P07 of the gate pattern GE and the non-overlapping portion IS2 of the gate inner spacer GIS in the third direction D3.

For example, the intermediate insulation structure MDI may include an insulating material. For example, the intermediate insulation structure MDI may include silicon oxide, silicon nitride, or silicon oxynitride.

At least one dummy channel pattern may be interposed between the lower channel pattern LCH1 and the upper channel pattern UCH1 thereon, and an intermediate insulation structure MDI may be interposed between the dummy channel patterns. For example, a second dummy channel pattern DS2 and a third dummy channel pattern DS3 may be located between the lower channel pattern LCH1 and the upper channel pattern UCH1, and an intermediate insulation structure MDI may be interposed between the second dummy channel pattern DS2 and the third dummy channel pattern DS3.

For example, the second dummy channel pattern DS2 and the third dummy channel pattern DS3 may be located between the second semiconductor pattern SP2 located at the uppermost position in the lower channel pattern LCH1 and the third semiconductor pattern SP3 located at the lowermost position in the upper channel pattern UCH1. Additionally, the second dummy channel pattern DS2 and the third dummy channel pattern DS3 may be located between the third sub-gate portion P03 located at the uppermost portion in the lower gate structure LGE and the fourth sub-gate portion P04 located at the lowermost portion in the upper gate structure UGE.

In other words, the second semiconductor pattern SP2 of the lower channel pattern LCH1, the third sub-gate portion PO3 of the lower gate structure LGE, the second dummy channel pattern DS2, the intermediate insulation structure MDI, the third dummy channel pattern DS3, the fourth sub-gate portion PO4 of the upper gate structure UGE, and the third semiconductor pattern SP3 of the upper channel pattern UCH1 may be sequentially stacked in the third direction D3.

The second dummy channel pattern DS2 and the third dummy channel pattern DS3 may be spaced apart from the lower source/drain pattern LSD1 and the upper source/drain pattern USD1. For example, a buried insulation layer SDI described later may be located next to the second direction D2 of the second dummy channel pattern DS2 and the third dummy channel pattern DS3, and the lower source/drain pattern LSD1 and the upper source/drain pattern USD1 may not be located next to the second and third dummy channel patterns DS2, DS3. Accordingly, the second dummy channel pattern DS2 and the third dummy channel pattern DS3 may not be connected to any source/drain pattern.

By means of the intermediate insulation structure MDI and the second dummy channel pattern DS2 and the third dummy channel pattern DS3 located on and under the intermediate insulation structure MDI, a threshold voltage (Vt) between the lower gate structure LGE and the upper gate structure UGE of the gate pattern GE may be controlled and variation thereof may be minimized.

At least one dummy channel pattern may be located on the upper channel pattern UCH1. For example, a fourth dummy channel pattern DS4 may be located on the upper channel pattern UCH1.

For example, the fourth dummy channel pattern DS4 may be located on the fourth semiconductor pattern SP4 located at the uppermost position of the upper channel pattern UCH1. Additionally, the fourth dummy channel pattern DS4 may be located on a sixth sub-gate portion P06 described later, which is located at the uppermost position of the upper gate structure UGE.

In other words, the fourth semiconductor pattern SP4 of the upper channel pattern UCH1, the sixth sub-gate portion P06 of the upper gate structure UGE, and the fourth dummy channel pattern DS4 may be sequentially stacked in the third direction D3.

The second dummy channel pattern DS2, the third dummy channel pattern DS3, and the fourth dummy channel pattern DS4 may include a semiconductor material, such as silicon (Si), germanium (Ge), or silicon germanium (SiGe), or a silicon-based insulating material, such as a silicon oxide layer or a silicon nitride layer. For example, the second dummy channel pattern DS2, the third dummy channel pattern DS3, and the fourth dummy channel pattern DS4 may include a silicon-based insulating material.

A first hardmask HM1 may be located on a fourth dummy channel pattern DS4. For example, a first hardmask HM1 may be located on each side of the main gate structure MGE in the second direction D2.

For example, the level of the lower surface of the first hardmask HM1 may be lower than the level of the lower surface of the main gate structure MGE. In some implementations, the level of the lower surface of the first hardmask HM1 may be higher than the level of the lower surface of the main gate structure MGE. In some implementations, the level of the lower surface of the first hardmask HM1 may be substantially the same as the level of the lower surface of the main gate structure MGE. For example, the level of the upper surface of the first hardmask HM1 may be lower than the level of the upper surface of the main gate structure MGE.

Here, the level of the lower surface or upper surface of the first hardmask HM1 may mean the shortest distance in the third direction D3 from the lower surface of the active pattern AP1 to the lower surface or upper surface of the first hardmask HM1.

For example, the first hardmask HM1 may include an insulating material, and the insulating material may include SiCN, SiOCN, SiN, or a combination thereof. The first hardmask HM1 may include multi-layers each including SiCN, SiOCN, SiN, or a combination thereof.

A first etch stop layer ESL1 may be located on the first hardmask HM1 and the second hardmask HM2. However, the first etch stop layer ESL1 may not be located on the main gate structure MGE. Additionally, the first etch stop layer ESL1 may not be located between the second hardmask HM2 and the gate cutting pattern CT. For example, the first etch stop layer ESL1 may be located on each side of the main gate structure MGE in the second direction D2. Additionally, the first etch stop layer ESL1 may be located on the non-overlapping portion IS2 of the gate inner spacer GIS.

The first etch stop layer ESL1 may include, for example, silicon nitride (SiN), silicon oxynitride (SiON), silicon oxycarbonitride (SiOCN), silicon boron nitride (SiBN), silicon oxyboron nitride (SiOBN), or silicon oxycarbide (SiOC).

The upper source/drain pattern USD1 may be located on the upper surface of the buried insulation layer SDI. The upper source/drain pattern USD1 may be an epitaxial pattern formed by a selective epitaxial growth (SEG) process. For example, the upper surface of the upper source/drain pattern USD1 may be higher than the upper surface of the fourth semiconductor pattern SP4 of the upper channel pattern UCH1.

The upper source/drain pattern USD1 may be doped with impurities to have a second conductivity type. The second conductivity type may be different from the first conductivity type of the lower source/drain pattern LSD1. For example, the second conductivity type may be P type. The upper source/drain pattern USD1 may include silicon germanium (SiGe) or silicon (Si).

A buried insulation layer SDI may be interposed between the lower source/drain pattern LSD1 and the upper source/drain pattern USD1 thereon. For example, the buried insulation layer SDI may be located between the upper surface of the lower source/drain pattern LSD1 and the lower surface of the upper source/drain pattern USD1.

The buried insulation layer SDI may separate the lower source/drain pattern LSD1 and the upper source/drain pattern USD1 from each other in the third direction D3. The buried insulation layer SDI may be overlapped with the lower source/drain pattern LSD1 and the upper source/drain pattern USD1 in the third direction D3.

The buried insulation layer SDI may include an insulating material. For example, the buried insulation layer SDI may include silicon nitride, silicon oxynitride, or a combination thereof.

The semiconductor device may further include a second interlayer insulation layer 120. The second interlayer insulation layer 120 may be located on the upper surface of the upper source/drain pattern USD1. The second interlayer insulation layer 120 may be located on the upper surface of the partition wall pattern 150. The second interlayer insulation layer 120 may be located on the side of the main gate structure MGE. The second interlayer insulation layer 120 may be located on the side of the gate capping pattern GP and the side of the gate cutting pattern CT described later. For example, the second interlayer insulation layer 120 may include, for example, silicon oxide (SiO₂), silicon nitride (SiN), silicon oxynitride (SiON), or a low-k material.

In some implementations, a second interlayer stop layer may be further located between the upper gate structure UGE and the second interlayer insulation layer and between the upper source/drain pattern USD1 and the second interlayer insulation layer. The second interlayer stop layer may include a material having an etch selectivity for the second interlayer insulation layer. The second interlayer stop layer may include, for example, silicon nitride (SiN), silicon oxynitride (SiON), silicon oxycarbonitride (SiOCN), silicon boron nitride (SiBN), silicon oxyboron nitride (SiOBN), or silicon oxycarbide (SiOC).

The gate pattern GE may be located on the lower channel pattern LCH1 and the upper channel pattern UCH1. The gate pattern GE may be overlapped with the stacked lower channel pattern LCH1 and upper channel pattern UCH1 in the third direction D3.

The gate pattern GE may extend in a third direction D3 from the upper surface of the device isolation layer ST or the upper surface of the active pattern AP1 to the gate capping pattern GP. The gate pattern GE may extend in a third direction D3 from the lower channel pattern LCH1 of the first active region AR1 to the upper channel pattern UCH1 of the second active region AR2. In other words, the gate pattern GE may extend in the third direction D3 from the first semiconductor pattern SP1 at the lowermost portion to the fourth semiconductor pattern SP4 at the uppermost portion.

The gate pattern GE may be located on the upper surface, the bottom surface, and both side surfaces of each of the first semiconductor pattern SP1, the second semiconductor pattern SP2, the third semiconductor pattern SP3, and the fourth semiconductor pattern SP4. In other words, the logic cell may include a three-dimensional field-effect transistor (e.g., a Multi-Bridge Channel FET (MBCFET) or a Gate-All-Around FET (GAAFET)) in which the gate pattern GE surrounds the channel three-dimensionally.

The gate pattern GE may have a lower gate structure LGE located within a first active region AR1, an upper gate structure UGE located within a second active region AR2, and a main gate structure MGE located on the upper gate structure UGE. The lower gate structure LGE, the upper gate structure UGE, and the main gate structure MGE may be overlapped with each other in a third direction D3. The lower gate structure LGE, the upper gate structure UGE, and the main gate structure MGE may be connected to each other. In other words, the gate pattern GE may be a common gate electrode in which a lower gate structure LGE on the lower channel pattern LCH1, an upper gate structure UGE on the upper channel pattern UCH1, and a main gate structure MGE are connected to each other.

The lower gate structure LGE may have a first sub-gate portion P01 interposed between the active pattern AP1 and the first semiconductor pattern SP1, a second sub-gate portion P02 interposed between the first semiconductor pattern SP1 and the second semiconductor pattern SP2, and a third sub-gate portion P03 interposed between the second semiconductor pattern SP2 and the second dummy channel pattern DS2.

The upper gate structure UGE may have a fourth sub-gate portion P04 interposed between a third dummy channel pattern DS3 and a third semiconductor pattern SP3, a fifth sub-gate portion P05 interposed between the third semiconductor pattern SP3 and the fourth semiconductor pattern SP4, and a sixth sub-gate portion P06 located between the fourth semiconductor pattern SP4 and the fourth dummy channel pattern DS4.

The main gate structure MGE may be located on the sixth sub-gate portion P06 of the upper gate structure UGE. For example, the main gate structure MGE may be located on the upper channel pattern UCH1 and may be located on the fourth semiconductor pattern SP4 located on the uppermost end of the upper channel pattern UCH1. For example, the main gate structure MGE may be located on the fourth dummy channel pattern DS4.

For example, the lower gate structure LGE may include a first work function metal pattern located on the first and second semiconductor patterns SP1 and SP2. The upper gate structure UGE and the main gate structure MGE may include a second work function metal pattern located on the third and fourth semiconductor patterns SP3 and SP4. Each of the first and second work function metal patterns may include a metal including titanium (Ti), tantalum (Ta), aluminum (Al), tungsten (W), molybdenum (Mo), or a combination thereof, and nitrogen (N). The first and second work function metal patterns may have different work functions. The gate pattern GE may include a low-resistivity metal, for example, including tungsten (W), ruthenium (Ru), aluminum (Al), titanium (Ti), tantalum (Ta), or a combination thereof, on the first and second work function metal patterns. For example, the main gate structure MGE may include a low-resistivity metal.

The gate pattern GE may further have a sub-gate connection portion P07 located on both sides in the first direction D1 of the lower channel pattern LCH1 and the upper channel pattern UCH1. For example, the sub-gate connection portion P07 may be located on both sides in the first direction D1 of the first to fourth semiconductor patterns SP1, SP2, SP3, and SP4. For example, the sub-gate connection portion P07 may be in contact with both side surfaces in the first direction D1 of the first to fourth semiconductor patterns SP1 to SP4.

The sub-gate connection portion P07 may be located on both sides in the first direction D1 of the first to sixth sub-gate portions P01 to P06, and the sub-gate connection portion P07 may be in contact with both sides in the first direction D1 of the first to sixth sub-gate portions P01 to P06. In addition, the sub-gate connection portion P07 extends in the third direction D3 from the first sub-gate portion P01 located at the lowermost end to the sixth sub-gate portion P06 located at the uppermost end, so as to pass through the side surfaces of the first to sixth sub-gate portions P01 to P06 and connect the first to sixth sub-gate portions P01 to P06. For example, the sub-gate connection portion P07 may extend in the third direction D3 from the upper surface of the device isolation layer ST to the lower surface of the main gate structure MGE.

The sub-gate connection portion P07 may not be overlapped with the lower channel pattern LCH1 and the upper channel pattern UCH1 in the third direction D3. For example, the sub-gate connection portion P07 may not be overlapped with the first to fourth semiconductor patterns SP1 to SP4 in the third direction D3.

Meanwhile, the first to sixth sub-gate portions P01 to P06 may be overlapped with the first to fourth semiconductor patterns SP1 to SP4 in the third direction D3. Accordingly, the sub-gate connection portion P07 may not be overlapped with the first to sixth sub-gate portions P01 to P06 in the third direction D3.

Additionally, the first to sixth sub-gate portions P01 to P06 may be located on the active pattern AP1. On the other hand, the sub-gate connection portion P07 may be located on the device isolation layer ST.

As described above, one lower gate structure LGE of the gate pattern GE and an upper gate structure UGE located thereon may be separated from another lower gate structure LGE and an upper gate structure UGE located thereon adjacent thereto in the second direction D2 by a partition wall pattern 150.

The first to sixth sub-gate portions P01 to P06 of the gate pattern GE may be located between the partition wall pattern 150 in the first direction D1, and the first to sixth sub-gate portions P01 to P06 may not contact the partition wall pattern 150, but the sub-gate connection portion P07 may be located between the first to sixth sub-gate portions P01 to P06 and the partition wall pattern 150 and may contact the first to sixth sub-gate portions P01 to P06 and the partition wall pattern 150.

Accordingly, the gate pattern GE may extend in the first direction D1 from one partition wall pattern 150 to another partition wall pattern 150 adjacent thereto in the first direction D1. For example, a gate pattern GE may be in contact with one partition wall pattern 150 and another partition wall pattern 150 adjacent thereto in the first direction D1. The gate pattern GE may further have a main gate connection portion P08 located on the partition wall pattern 150.

The main gate connection portion P08 may be located between one main gate structure MGE and another main gate structure MGE arranged in the first direction D1 with one of the partition wall patterns 150 interposed therebetween. One main gate structure MGE arranged in the first direction D1 with one of the partition wall patterns 150 interposed therebetween may be connected to another main gate structure MGE by a main gate connection portion PO8. By this, the gate pattern GE may be extended in the first direction D1.

Since the gate pattern GE extends in the first direction D1 only on the partition wall pattern 150, the height of the lower surface of the gate pattern GE may be prevented from being recessed, thereby reducing parasitic capacitance, and since the metal of the gate pattern GE is protected by the partition wall pattern 150, changes in the threshold voltage (Vₜ) may be minimized.

For example, the level of the lower surface of the main gate connection portion P08 may be lower than the level of the lower surface of the main gate structure MGE. In some implementations, the level of the lower surface of the main gate connection portion P08 may be higher than the level of the lower surface of the main gate structure MGE. In some implementations, the level of the lower surface of the main gate connection portion P08 may be substantially the same as the level of the lower surface of the main gate structure MGE.

Here, the level of the lower surface of the main gate connection portion P08 or the lower surface of the main gate structure MGE may mean the shortest distance in the third direction D3 from the lower surface of the active pattern AP1 to the lower surface of the main gate connection portion PO8 or the lower surface of the main gate structure MGE.

A gate inner spacer GIS may be located between the gate pattern GE and the lower source/drain pattern LSD1 and the upper source/drain pattern USD1. For example, the gate inner spacer GIS may be located between the first to third sub-gate portion P01 to P03 of the lower gate structure LGE and the lower source/drain pattern LSD1, and may be located between the fourth to sixth sub-gate portions P04 to P06 of the upper gate structure UGE and the upper source/drain pattern USD1. The gate inner spacer GIS may extend in the first direction D1 along the gate pattern GE.

For example, in a cross-sectional view (e.g., FIG. 2), the gate inner spacer GIS may be located on each side of the first to sixth sub-gate portions P01 to P06 in the second direction D2.

The gate inner spacer GIS may have an overlapping portion IS1 that is overlapped with the upper channel pattern UCH1 and the lower channel pattern LCH1 in a third direction D3 and a non-overlapping portion IS2 that is not overlapped with the upper channel pattern UCH1 and the lower channel pattern LCH1 in the third direction D3.

For example, the overlapping portion IS1 may be located between the first to fourth semiconductor patterns SP1 to SP4 in the third direction D3. For example, the overlapping portion IS1 may be located between the active pattern AP1 and the first semiconductor pattern SP1, between the first semiconductor pattern SP1 and the second semiconductor pattern SP2, between the second semiconductor pattern SP2 and the second dummy channel pattern DS2, between the third dummy channel pattern DS3 and the third semiconductor pattern SP3, between the third semiconductor pattern SP3 and the fourth semiconductor pattern SP4, and between the fourth semiconductor pattern SP4 and the fourth dummy channel pattern DS4, respectively.

For example, the non-overlapping portion IS2 may be located on both sides in the first direction D1 of the first to fourth semiconductor patterns SP1, SP2, SP3, and SP4. For example, the non-overlapping portion IS2 may be in contact with both side surfaces in the first direction D1 of the first to fourth semiconductor patterns SP1 to SP4. Additionally, the non-overlapping portion IS2 may be located on both sides of the overlapping portion IS1 in the first direction D1, and the non-overlapping portion IS2 may be in contact with both sides of the overlapping portion IS1 in the first direction D1.

The non-overlapping portion IS2 may extend in the third direction D3 from the first semiconductor pattern SP1 located at the lowermost end to the fourth semiconductor pattern SP4 located at the uppermost end. In addition, the non-overlapping portion IS2 may extend in the third direction D3 from the overlapping portion IS1 located at the bottom to the overlapping portion IS1 located at the uppermost end, passing through the side of the overlapping portions IS1 and connecting the overlapping portions IS1. For example, the non-overlapping portion IS2 may extend in the third direction from the upper surface of the device isolation layer ST to the lower surface of the first etch stop layer ESL1. The non-overlapping portion IS2 may be in contact with the upper surface of the device isolation layer ST and the lower surface of the first etch stop layer ESL1.

Meanwhile, the overlapping portion IS1 may be located on the active pattern AP1, and the non-overlapping portion IS2 may be located on the device isolation layer ST. For example, one gate inner spacer GIS may be separated from another gate inner spacer GIS adjacent to it in the first direction D1 by a partition wall pattern 150. The overlapping portion IS1 of the gate inner spacer GIS is located between the partition walls patterns 150 in the first direction D1, and the overlapping portion IS1 does not contact the partition wall pattern 150, but the non-overlapping portion IS2 is located between the overlapping portion IS1 and the partition wall pattern 150 and may contact the overlapping portion IS1 and the partition wall pattern 150.

Accordingly, the gate inner spacer GIS may extend in the first direction D1 from one partition wall pattern 150 to another partition wall pattern 150 adjacent thereto in the first direction D1. For example, a gate inner spacer GIS may be in contact with one partition wall pattern 150 and another partition wall pattern 150 adjacent thereto in the first direction D1.

For example, the thicknesses of the overlapping portion IS1 and the non-overlapping portion IS2 of the gate inner spacer GIS in the second direction D2 may be substantially the same. For example, the thickness in the second direction D2 of the overlapping portion IS1 and the non-overlapping portion IS2 may be about 4 nm or more, about 5 nm or more, about 6 nm or more, or about 7 nm or more, and may be about 8 nm or less, about 7 nm or less, about 6 nm or less, or about 5 nm or less, for example, about 4 nm to about 8 nm.

The length of the non-overlapping portion IS2 in the first direction D1 may be about 4 nm or more, about 5 nm or more, about 6 nm or more, about 7 nm or more, about 8 nm or more, about 9 nm or more, about 10 nm or more, about 11 nm or more, about 12 nm or more, about 13 nm or more, or about 14 nm or more, and may be about 15 nm or less, about 14 nm or less, about 13 nm or less, about 12 nm or less, about 11 nm or less, about 10 nm or less, about 9 nm or less, about 8 nm or less, about 7 nm or less, or about 6 nm or less, for example, about 5 nm to about 15 nm.

As an example, the gate inner spacer GIS may include a low-k material. The low-k material may include silicon oxide, or a material having a lower dielectric constant than silicon oxide. For example, the low-k material may include silicon oxide, silicon oxide doped with fluorine or carbon, porous silicon oxide, or an organic polymeric dielectric. However, the present disclosure is not limited thereto, and the gate inner spacer GIS may include, for example, silicon nitride (SiN), silicon oxynitride (SiON), silicon oxide (SiO₂), silicon oxycarbonitride (SiOCN), silicon boron nitride (SiBN), silicon oxyboron nitride (SiOBN), silicon oxycarbide (SiOC), or a combination thereof.

In this way, the gate inner spacer GIS has an overlapping portion IS1 that is overlapped with the lower channel pattern LCH1 and the upper channel pattern UCH1 in a third direction D3 and a non-overlapping portion IS2 that is not overlapped therewith in the third direction D3, and the gate inner spacer GIS extends in the first direction D1 to one partition wall pattern 150 and another partition wall pattern 150 adjacent thereto in the first direction D1, so that the gate inner spacer GIS may be located on the entire surface of the gate pattern GE that contacts the lower source/drain pattern LSD1 and the upper source/drain pattern USD1, thereby preventing the gate pattern GE from being damaged when the lower source/drain contact bCA is formed.

A pair of gate spacers GS may be respectively placed on both side surfaces of the sixth sub-gate portion P06 of the gate pattern GE. The gate spacers GS may extend in a first direction D1 along the gate pattern GE.

The upper surfaces of the gate spacers GS may be higher than the upper surface of the gate pattern GE. The upper surfaces of the gate spacers GS may be coplanar with the upper surface of the second interlayer insulation layer 120.

The gate spacers GS may include SiCN, SiOCN, SiN, or a combination thereof. For example, the gate spacers GS may include multi-layers each including SiCN, SiOCN, SiN, or a combination thereof.

A gate capping pattern GP may be located on the upper surface of the gate pattern GE. The gate capping pattern GP may extend in the first direction D1 along the gate pattern GE. For example, the gate capping pattern GP may include SiON, SiCN, SiOCN, SiN, or a combination thereof.

In some implementations, a gate insulation layer may be interposed between the gate pattern GE and the first to fourth semiconductor patterns SP1 to SP4. The gate insulation layer may include a silicon oxide layer, a silicon oxynitride layer, a high-k layer, or a combination thereof. For example, the gate insulation layer may include a silicon oxide layer directly covering the surfaces of the first to fourth semiconductor patterns SP1 to SP4 and a high-k layer located on the silicon oxide layer. In other words, the gate insulation layer may include a multi-layer of a silicon oxide layer and a high-k dielectric layer.

The high-k dielectric layer may include a high-k material having a higher dielectric constant than the silicon oxide layer. For example, the high-k material may include hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, lead zinc niobate, or a combination thereof.

The upper source/drain contact aCA may be electrically connected to the upper source/drain pattern USD1 by penetrating the second interlayer insulation layer 120. Additionally, the upper gate contact aCB may be electrically connected to the main gate structure MGE by penetrating the second interlayer insulation layer 120 and the gate capping pattern GP.

In some implementations, each of the upper source/drain contact aCA and the upper gate contact aCB may include a conductive pattern and a barrier pattern surrounding the conductive pattern. For example, the conductive pattern may include aluminum, copper, tungsten, molybdenum, or a combination thereof. The barrier pattern may cover the sides and bottom surface of the conductive pattern. The barrier pattern may include a metal layer or a metal nitride layer. The metal layer may include titanium, tantalum, tungsten, nickel, cobalt, platinum, or a combination thereof. The metal nitride layer may include titanium nitride (TiN), tantalum nitride (TaN), tungsten nitride (WN), nickel nitride (NiN), cobalt nitride (CoN), platinum nitride (PtN), or a combination thereof.

In some implementations, silicide patterns may be interposed between the upper source/drain contact aCA and the upper source/drain pattern USD1 and between the upper gate contact aCB and the main gate structure MGE. The upper source/drain contact aCA may be electrically connected to the upper source/drain contact aCA through the silicide pattern, and the upper gate contact aCB may be electrically connected to the main gate structure MGE through the silicide pattern. The silicide pattern may include a metal-silicide, for example titanium-silicide, tantalum-silicide, tungsten-silicide, nickel-silicide, cobalt-silicide, or a combination thereof.

In some implementations, a first upper interlayer insulation layer may be located on the upper source/drain contact aCA and the upper gate contact aCB and may cover the upper source/drain contact aCA and the upper gate contact aCB.

Additionally, a first upper metal layer may be disposed within the first upper interlayer insulation layer. The first upper metal layer may include first upper power wirings, first upper wirings, and first upper vias. The first upper vias may be located beneath the first upper power wirings and the first upper wirings. The first upper vias may be interposed between the upper source/drain contact aCA and the first upper power wirings and the first upper wirings, respectively. Additionally, the first upper vias may be interposed between the upper gate contact aCB and the first upper wirings, respectively.

The first upper power wirings and the first upper wirings of the first upper metal layer may include the same or different conductive materials. For example, the first upper power lower wirings and the first upper lower wirings may include aluminum, copper, tungsten, molybdenum, cobalt, or a combination thereof.

In some implementations, additional upper metal layers may be disposed on the first upper interlayer insulation layer. Each of the stacked upper metal layers may include routing wirings.

A lower source/drain contact bCA may be located under the lower source/drain pattern LSD1 and may be electrically connected to the lower source/drain pattern LSD1. For example, the lower source/drain contact bCA may penetrate the active pattern AP1 and may be electrically connected to the lower source/drain pattern LSD1.

Additionally, a bottom gate contact bCB may be located under the bottom gate structure LGE and may be electrically connected to the bottom gate structure LGE. For example, the bottom gate contact bCB may penetrate the active pattern AP1 and may be electrically connected to the bottom gate structure LGE.

An insulation liner CBL may be further located between the lower source/drain contact bCA and the adjacent lower gate contact bCB. The insulation liner CBL may include, for example, silicon nitride (SiN), silicon oxynitride (SiON), silicon oxycarbonitride (SiOCN), silicon boron nitride (SiBN), silicon oxyboron nitride (SiOBN), or silicon oxycarbide (SiOC).

In some implementations, each of the lower source/drain contact bCA and the lower gate contact bCB may include a conductive pattern and a barrier pattern surrounding the conductive pattern. For example, the conductive pattern may include a metal including aluminum, copper, tungsten, molybdenum, or a combination thereof. The barrier pattern may cover the sides and bottom surface of the conductive pattern. The barrier pattern may include a metal layer or a metal nitride layer. The metal layer may include titanium, tantalum, tungsten, nickel, cobalt, platinum, or a combination thereof. The metal nitride layer may include titanium nitride (TiN), tantalum nitride (TaN), tungsten nitride (WN), nickel nitride (NiN), cobalt nitride (CoN), platinum nitride (PtN), or a combination thereof.

In some implementations, silicide patterns may be interposed between the lower source/drain contact bCA and the lower source/drain pattern LSD1 and between the lower gate contact bCB and the lower gate structure LGE. The lower source/drain contact bCA may be electrically connected to the lower source/drain pattern LSD1 through the silicide pattern, and the lower gate contact bCB may be electrically connected to the lower gate structure LGE through the silicide pattern. The silicide pattern may include a metal-silicide, for example titanium-silicide, tantalum-silicide, tungsten-silicide, nickel-silicide, cobalt-silicide, or a combination thereof.

In some implementations, the first lower interlayer insulation layer may be located under the lower source/drain contact bCA and the lower gate contact bCB, and may cover the lower source/drain contact bCA and the lower gate contact bCB.

Additionally, a first lower metal layer may be disposed within the first lower interlayer insulation layer. The first lower metal layer may include first lower power wirings, first lower wirings, and first lower vias. The first lower vias may be located on the first lower power wirings and the first lower wirings. The first lower vias may be interposed between the lower source/drain contact bCA and the first lower power wirings and the first lower wirings, respectively. Additionally, the first lower vias may be interposed between the lower gate contact bCB and the first lower wirings, respectively.

The first lower power wirings and the first lower wirings of the first lower metal layer may include the same or different conductive materials. For example, the first sub-power wirings and the first lower wirings may include aluminum, copper, tungsten, molybdenum, cobalt, or a combination thereof.

In some implementations, additional lower metal layers may be located beneath the first lower interlayer insulation layer. Each of the stacked lower metal layers may include routing lower wirings.

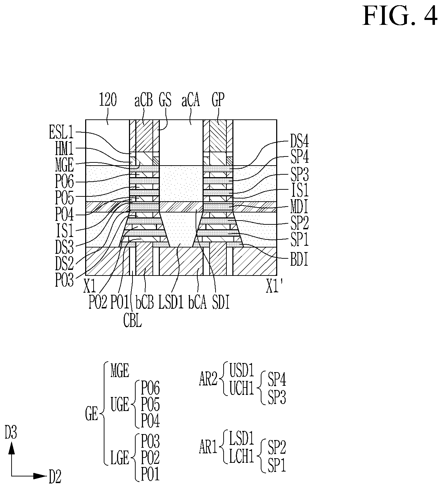

FIG. 4 is a cross-sectional view showing an example of a semiconductor device according to some implementations, taken along line X1-X1' of FIG. 1. The implementation illustrated in FIG. 4 is substantially the same as the implementation illustrated in FIG. 2, and a description thereof will be omitted and the differences will be mainly explained. Additionally, the same drawing symbols are used for the same components as in the previous embodiment.

In FIG. 2, the length of the lower insulation structure BDI in the second direction D2 is shown to be substantially the same as the length of the intermediate insulation structure MDI in the second direction D2, and the lengths of the first to third sub-gate portion P01 to P03 of the lower gate structure LGE in the second direction D2 are shown to be substantially the same as the lengths of the fourth to sixth sub-gate portions P04 to P06 of the upper gate structure UGE in the second direction D2.

In FIG. 4, the length of the lower insulation structure BDI in the second direction D2 may be greater than the length of the intermediate insulation structure MDI in the second direction D2. Additionally, the length of the first to third sub-gate portion P01 to P03 of the lower gate structure LGE in the second direction D2 may be greater than the length of the fourth to sixth sub-gate portions P04 to P06 of the upper gate structure UGE in the second direction D2.

Accordingly, the lower source/drain contact bCA and the lower gate contact bCB may be formed more easily by self-alignment without an additional structure, such as a place holder, the gate pattern GE may be prevented from being damaged when the lower source/drain contact bCA is formed, and the work function metal of the gate pattern GE may be protected, so that the threshold voltage (Vₜ) change may be minimized.

For example, the length of the lower insulation structure BDI in the second direction D2 may be greater than the length of the first to third sub-gate portions P01 to P03 of the lower gate structure LGE in the second direction D2.

The lengths of the first to third sub-gate portions P01 to P03 of the lower gate structure LGE in the second direction D2 may become smaller as they go upward in the third direction D3. For example, the length of the first sub-gate portion P01 in the second direction D2 may be greater than the length of the second sub-gate portion P02 in the second direction D2. The length of the second sub-gate portion P02 in the second direction D2 may be greater than the length of the third sub-gate portion P03 in the second direction D2.

The length of the first to third sub-gate portions P01 to P03 of the lower gate structure LGE in the second direction D2 may be greater than the length of the intermediate insulation structure MDI in the second direction D2. For example, the length of the third sub-gate portion P03 of the lower gate structure LGE in the second direction D2 may be greater than the length of the intermediate insulation structure MDI in the second direction D2.

The length of the intermediate insulation structure MDI in the second direction D2 may be greater than the length of the fourth to sixth sub-gate portions P04 to P06 of the upper gate structure UGE in the second direction D2. For example, the length of the intermediate insulation structure MDI in the second direction D2 may be greater than the length of the fourth sub-gate portion P04 of the upper gate structure UGE in the second direction D2.

The length of the fourth to sixth sub-gate portions P04 to P06 of the upper gate structure UGE in the second direction D2 may become smaller as it goes upward in the third direction D3. For example, the length of the fourth sub-gate portion P04 in the second direction D2 may be greater than the length of the fifth sub-gate portion P05 in the second direction D2. The length of the fifth sub-gate portion P05 in the second direction D2 may be greater than the length of the sixth sub-gate portion P06 in the second direction D2.

For example, the length of the lower insulation structure BDI in the second direction D2 may be longer than the length of the intermediate insulation structure MDI in the second direction D2, by about 1 nm or more, for example about 2 nm or more, about 3 nm or more, about 4 nm or more, or about 5 nm or more.

Additionally, the length of the first to third sub-gate portions P01 to P03 of the lower gate structure LGE in the second direction D2 may be larger than the length of the fourth to sixth sub-gate portions P04 to P06 of the upper gate structure UGE in the second direction D2, by about 1 nm or more, for example about 2 nm or more, about 3 nm or more, about 4 nm or more, or about 5 nm or more.

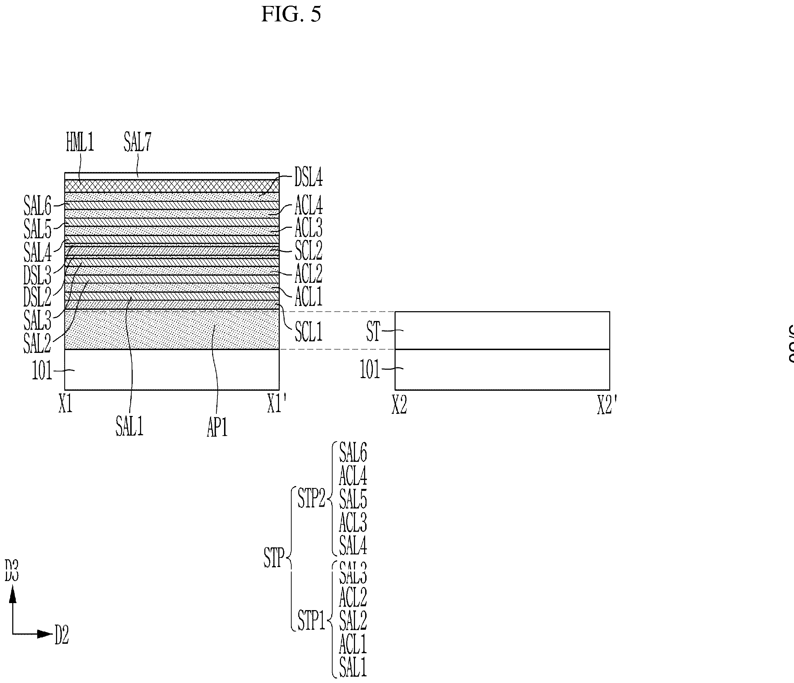

Next, examples of a method for manufacturing a semiconductor device according to some implementations will be described with reference to FIGS. 5 to 30. In addition, reference may be made to FIGS. 1 to 3 described above.

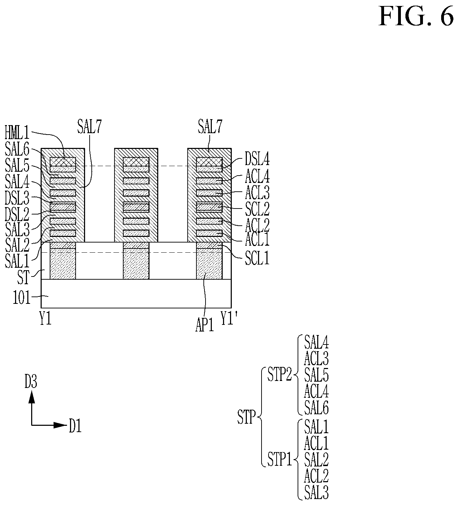

FIGS. 5 to 30 are cross-sectional views showing examples of a method for manufacturing a semiconductor device according to some implementations. FIG. 5 shows cross-sectional views taken along lines X1-X1' and X2-X2' of FIG. 1 according to some implementations. FIG. 6 shows a cross-sectional view taken along line Y1-Y1' of FIG. 1 according to some implementations. At this time, the cross-sectional view cut along the Y2-Y2' line and the Y3-Y3' line of FIG. 1 may be the same as FIG. 6, and it is omitted.

In FIGS. 5 and 6, a first high-concentration sacrificial layer SCL1 may be stacked on a lower substrate 101, and first to third low-concentration sacrificial layers SAL1 to SAL3 and first and second active layers ACL1 and ACL2 may be alternately stacked on the first high-concentration sacrificial layer SCL1. In other words, a first high-concentration sacrificial layer SCL1, a first low-concentration sacrificial layer SAL1, a first active layer ACL1, a second low-concentration sacrificial layer SAL2, a second active layer ACL2, and a third low-concentration sacrificial layer SAL3 may be sequentially stacked. Additionally, a second dummy layer DSL2, a second high-concentration sacrificial layer SCL2, and a third dummy layer DSL3 may be sequentially stacked on a third low-concentration sacrificial layer SAL3.

Additionally, fourth to sixth low-concentration sacrificial layers SAL4 to SAL6 and third and fourth active layers ACL3 and ACL4 may be alternately stacked on the third dummy layer DSL3. In other words, a third dummy layer DSL3, a fourth low-concentration sacrificial layer SAL4, a third active layer ACL3, a fifth low-concentration sacrificial layer SAL5, a fourth active layer ACL4, and a sixth low-concentration sacrificial layer SAL6 may be sequentially stacked.

Additionally, a fourth dummy layer DSL4 may be stacked on the sixth low-concentration sacrificial layer SAL6.

The lower substrate 101 may be a semiconductor substrate including silicon, germanium, silicon germanium, etc., or a compound semiconductor substrate. For example, the lower substrate 101 may be a silicon substrate.

The first to sixth low-concentration sacrificial layers SAL1 to SAL6 may include one of silicon (Si), germanium (Ge), or silicon germanium (SiGe). For example, the first to sixth low-concentration sacrificial layers SAL1 to SAL6 may include silicon germanium (SiGe), and the concentration of germanium (Ge) in each of the first to sixth low-concentration sacrificial layers SAL1 to SAL6 may be about 10 at% (atomic percent) to about 30 at%.

The first and second high-concentration sacrificial layers SCL1 and SCL2 may include silicon (Si) or silicon germanium (SiGe). When the first and second high-concentration sacrificial layers SCL1 and SCL2 include silicon germanium (SiGe), the concentration of germanium (Ge) in the first and second high-concentration sacrificial layers SCL1 and SCL2 may be greater than the concentration of germanium (Ge) in the first to sixth low-concentration sacrificial layers SAL1 to SAL6. For example, the concentration of germanium (Ge) in the first and second high-concentration sacrificial layers SCL1 and SCL2 may be about 40 at% to about 90 at%.

The first to fourth active layers ACL1 to ACL4 may include another one of silicon (Si), germanium (Ge), or silicon germanium (SiGe). For example, the first to fourth active layers ACL1 to ACL4 may include silicon (Si).

The first to fourth dummy layers DSL1 to DSL4 may include another one of silicon (Si), germanium (Ge), or silicon germanium (SiGe). For example, the first to fourth dummy layers DSL1 to DSL4 may include silicon (Si).

The first high-concentration sacrificial layer SCL1, the first low-concentration sacrificial layer SAL1, the first active layer ACL1, the second low-concentration sacrificial layer SAL2, the second active layer ACL2, the third low-concentration sacrificial layer SAL3, the second dummy layer DSL2, the second high-concentration sacrificial layer SCL2, the third dummy layer DSL3, the fourth low-concentration sacrificial layer SAL4, the third active layer ACL3, the fifth low-concentration sacrificial layer SAL5, the fourth active layer ACL4, the sixth low-concentration sacrificial layer SAL6, and the fourth dummy layer DSL4 may be patterned to form a stacked pattern STP.

For example, the stacked pattern STP may be formed by forming a first hardmask layer HML1 on a fourth dummy layer DSL4 at the uppermost portion, and etching the stacked layers on the lower substrate 101 using the first hardmask layer HML1 as an etching mask. While the stacked pattern STP is formed, the upper portion of the lower substrate 101 may be patterned to form a trench defining the active pattern AP1. The stacked pattern STP may have a bar shape extending in the second direction D2.

The first hardmask layer HML1 may include SiCN, SiOCN, SiN, or a combination thereof. For example, the first hardmask layer HML1 may include a multi-layer each including SiCN, SiOCN, SiN, or a combination thereof.

The stacked pattern STP may include a lower stacked pattern STP1 on an active pattern AP1 and an upper stacked pattern STP2 on the lower stacked pattern STP1. The lower stacked pattern STP1 may include alternately stacked first to third low-concentration sacrificial layers SAL1 to SAL3 and first and second active layers ACL1 and ACL2. The upper stacked pattern STP2 may include alternately stacked fourth to sixth low-concentration sacrificial layers SAL4 to SAL6 and third and fourth active layers ACL3 and ACL4.

A device isolation layer ST filling the trench may be formed on the lower substrate 101. For example, an insulation layer covering the active patterns AP1 and the stacked patterns STP may be formed on the entire surface of the lower substrate 101. The insulation layer may be recessed until the stacked pattern STP is exposed, thereby forming a device isolation layer ST. For example, the device isolation layer ST may expose the first low-concentration sacrificial layer SAL1 of the stacked patterns STP while covering the first high-concentration sacrificial layer SCL1.

A seventh low-concentration sacrificial layer SAL7 covering the stacked pattern STP may be formed on the device isolation layer ST. For example, a low-concentration sacrificial layer material is deposited on the stacked pattern STP to form a seventh low-concentration sacrificial layer SAL7. The seventh low-concentration sacrificial layer SAL7 may cover the upper surface of the stacked pattern STP and both side surfaces in the first direction D1. The seventh low-concentration sacrificial layer SAL7 may be formed conformally. In other words, the thickness of the portion of the seventh low-concentration sacrificial layer SAL7 located on the upper surface of the stacked pattern STP in the third direction D3 may be similar to the thickness of the portion of the seventh low-concentration sacrificial layer SAL7 located on the side surface of the stacked pattern STP in the first direction D1.

The seventh low-concentration sacrificial layer SAL7 may include one of silicon (Si), germanium (Ge), or silicon germanium (SiGe). For example, the seventh low-concentration sacrificial layer SAL7 may include silicon germanium (SiGe), and the concentration of germanium (Ge) in the seventh low-concentration sacrificial layer SAL7 may be about 10 at% to about 30 at%.

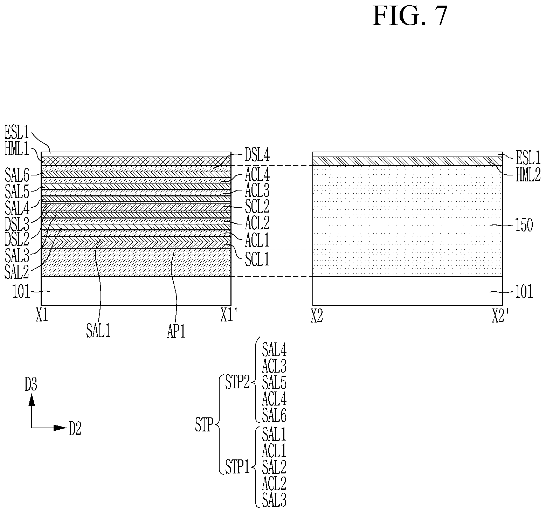

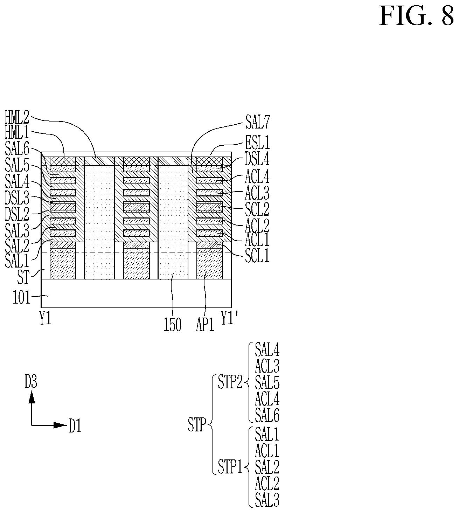

FIG. 7 shows cross-sectional views taken along lines X1-X1' and X2-X2' of FIG. 1 according to some implementations. FIG. 8 is a cross-sectional view taken along line Y1-Y1' of FIG. 1 according to some implementations. At this time, the cross-sectional view cut along the Y2-Y2' line and the Y3-Y3' line of FIG. 1 may be the same as FIG. 8, and it is omitted.

In FIGS. 7 and 8, after the device isolation layer ST is etched back until the lower substrate 101 is exposed, a partition wall pattern 150 is formed in the space between the stacked patterns STP. For example, the partition wall pattern 150 may be formed by filling an insulating material in the space between the stacked patterns STP and planarizing the insulating material until the first hardmask layer HML1 is exposed. The planarization of the insulating material may be performed using an etch back or chemical mechanical polishing (CMP) process.

During the planarization process, the seventh low-concentration sacrificial layer SAL7 located on the upper surface of the stacked pattern STP may be removed, leaving only the seventh low-concentration sacrificial layer SAL7 located on the side of the stacked pattern STP. Additionally, during the planarization process, the first hardmask layer HML1 may be completely removed or partially left behind.

As a result, the partition wall pattern 150 may extend in the third direction D3 from a level lower than the upper surface of the active pattern AP1 to a level higher than the upper surface of the sixth low-concentration sacrificial layer SAL6 of the upper stacked pattern STP2. For example, the lower surface of the partition wall pattern 150 may be coplanar with the upper surface of the lower substrate 101, and the upper surface of the partition wall pattern 150 may be coplanar with the upper surface of the fourth dummy layer DSL4 and the lower surface of the first hardmask layer HML1.

A second hardmask layer HML2 may be formed on the upper surface of the partition wall pattern 150 and in the space between the stacked patterns STP. For example, the second hardmask layer HML2 may be formed on the upper surface of the partition wall pattern 150 and the upper surface of the stacked pattern STP, and the second hardmask layer HML2 may be planarized until the first hardmask layer HML1 is exposed. The planarization of the second hardmask layer HML2 may be performed using an etch back or CMP (Chemical Mechanical Polishing) process.

The second hardmask layer HML2 may include SiCN, SiOCN, SiN, or a combination thereof. For example, the second hardmask layer HML2 may include a multi-layer each including SiCN, SiOCN, SiN, or a combination thereof.

A first etch stop layer ESL1 may be conformally formed on the first and second hardmask layers HML1 and HML2. The first etch stop layer ESL1 may cover the upper surface of the partition wall pattern 150 and the upper surface of the stacked pattern STP.

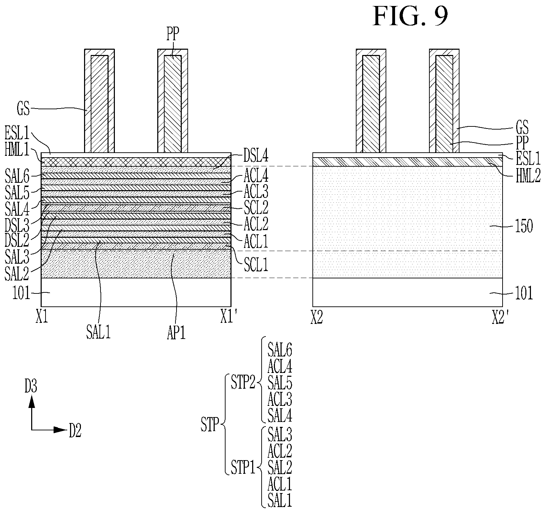

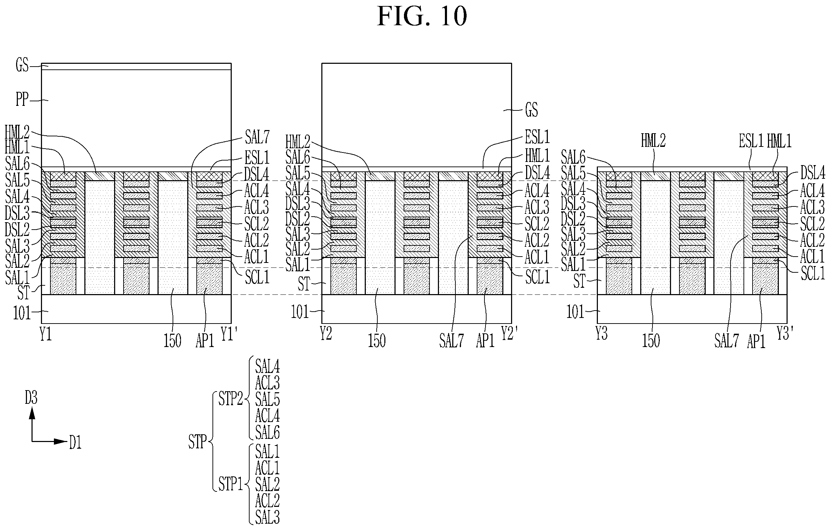

FIG. 9 shows cross-sectional views taken along lines X1-X1' and X2-X2' of FIG. 1 according to some implementations. FIG. 10 shows cross-sectional views taken along lines Y1-Y1', Y2-Y2', and Y3-Y3' of FIG. 1 according to some implementations.

In FIGS. 9 and 10, a plurality of sacrificial patterns PP may be formed across the stacked pattern STP. Each of the sacrificial patterns PP may be formed in a line shape extending in the first direction D1. For example, the sacrificial pattern PP may be formed by forming a sacrificial layer on a first etch stop layer ESL1, forming a hardmask pattern on the sacrificial layer, and patterning the sacrificial layer using the hardmask pattern as an etching mask. The sacrificial layer may include amorphous silicon or polysilicon.

A pair of gate spacers GS may be formed on each side surface in the second direction D2 of the sacrificial pattern PP. For example, a spacer layer may be conformally formed on the entire surface of the first etch stop layer ESL1 and the sacrificial pattern PP. The spacer layer may cover the first etch stop layer ESL1 and the sacrificial pattern PP. For example, the spacer layer may include SiCN, SiOCN, SiN, or a combination thereof.

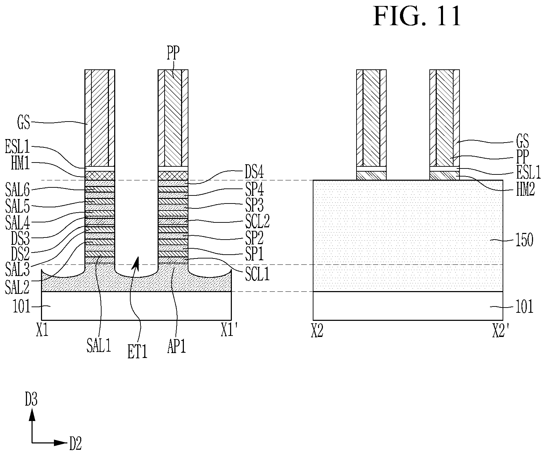

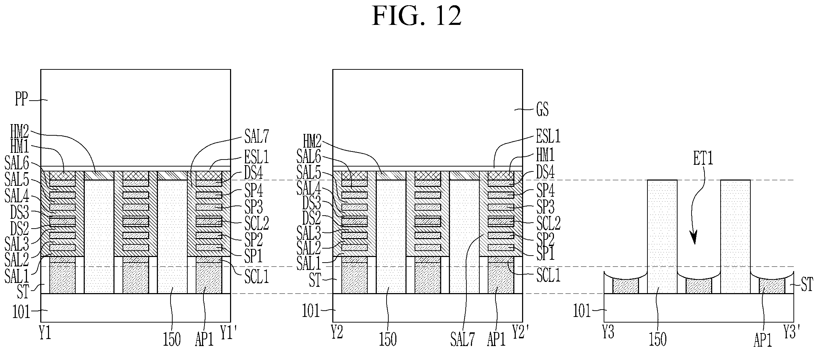

FIG. 11 shows cross-sectional views taken along lines X1-X1' and X2-X2' of FIG. 1 according to some implementations. FIG. 12 shows cross-sectional views taken along lines Y1-Y1', Y2-Y2', and Y3-Y3' of FIG. 1 according to some implementations.

In FIGS. 11 and 12, an etching process may be performed on the stacked pattern STP using gate spacers GS and a sacrificial pattern PP as etching masks.

For example, by an etching process, the stacked first high-concentration sacrificial layer SCL1, the first low-concentration sacrificial layer SAL1, the first active layer ACL1, the second low-concentration sacrificial layer SAL2, the second active layer ACL2, the third low-concentration sacrificial layer SAL3, the second dummy layer DSL2, the second high-concentration sacrificial layer SCL2, the third dummy layer DSL3, the fourth low-concentration sacrificial layer SAL4, the third active layer ACL3, the fifth low-concentration sacrificial layer SAL5, the fourth active layer ACL4, the sixth low-concentration sacrificial layer SAL6, and the fourth dummy layer DSL4 may be patterned to form a lower channel pattern LCH1 and an upper channel pattern UCH1.

The lower channel pattern LCH1 may include a first semiconductor pattern SP1 and a second semiconductor pattern SP2 that are stacked and spaced apart from each other in a third direction D3, and the upper channel pattern UCH1 may include a third semiconductor pattern SP3 and a fourth semiconductor pattern SP4 that are stacked and spaced apart from each other in a third direction D3.

Meanwhile, the first to third low-concentration sacrificial layers SAL1 to SAL3 may be alternately stacked between the first semiconductor pattern SP1 and the second semiconductor pattern SP2 of the lower channel pattern LCH1, and the fourth to sixth low-concentration sacrificial layers SAL4 to SAL6 may be alternately stacked between the third semiconductor pattern SP3 and the fourth semiconductor pattern SP4 of the upper channel pattern UCH1.

Additionally, the second dummy layer DSL2, the third dummy layer DSL3, and the fourth dummy layer DSL4 may also be patterned to form a second dummy channel pattern DS2, a third dummy channel pattern DS3, and a fourth dummy channel pattern DS4, respectively.

Additionally, the first and second hardmask layers HML1 and HML2 may also be patterned to form first and second hardmasks HM1 and HM2, respectively.

Accordingly, a first recess ET1 may be formed between the lower channel pattern LCH1 and the upper channel pattern UCH1.

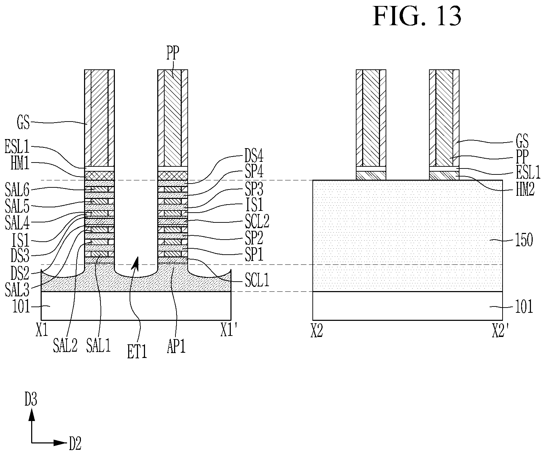

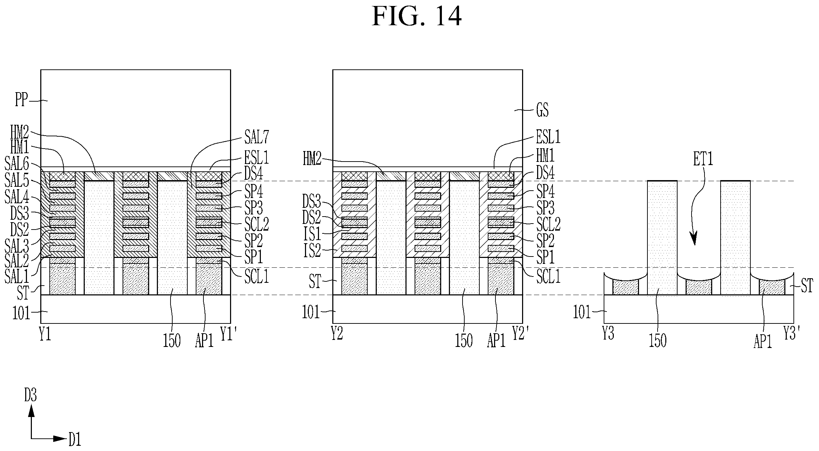

FIG. 13 shows cross-sectional views taken along lines X1-X1' and X2-X2' of FIG. 1 according to some implementations. FIG. 14 shows cross-sectional views taken along lines Y1-Y1', Y2-Y2', and Y3-Y3' of FIG. 1 according to some implementations.

Referring to FIGS. 13 and 14, a portion of both side surfaces of the first to sixth low-concentration sacrificial layers SAL1 to SAL6 exposed by the first recess ET1 in the second direction D2 may be removed, and a gate inner spacer GIS may be formed within the removed space.

For example, an indent process is performed on the first to sixth low-concentration sacrificial layers SAL1 to SAL6. In the indent process, the first to sixth low-concentration sacrificial layers SAL1 to SAL6 are etched using a wet etching or dry etching method, thereby reducing the length of the first to sixth low-concentration sacrificial layers SAL1 to SAL6 in the second direction D2.

At this time, the etchant used in the indentation process has a selectivity for the first to sixth low-concentration sacrificial layers SAL1 to SAL6 compared to the first and second high-concentration sacrificial layers SCL1 and SCL2, so that the first and second high-concentration sacrificial layers SCL1 and SCL2 are not etched, and only the first to sixth low-concentration sacrificial layers SAL1 to SAL6 are etched.

Meanwhile, the seventh low-concentration sacrificial layer SAL7 covering both side surfaces in the first direction D1 of the lower channel pattern LCH1 and the upper channel pattern UCH1 is also partially removed in the second direction D2 by an indent process, and its length is reduced in the second direction D2.

Next, a low-k material may be filled in the space where the first to seventh low-concentration sacrificial layers SAL1 to SAL7 are partially removed by the indentation process to form a gate inner spacer GIS. For example, an overlapping portion IS1 of a gate inner spacer GIS may be formed in a space from which a portion of the first to sixth low-concentration sacrificial layers SAL1 to SAL6 are removed, and a non-overlapping portion IS2 of a gate inner spacer GIS may be formed in a space from which a portion of the seventh low-concentration sacrificial layer SAL7 is removed.

The low-k dielectric material may be deposited using an atomic layer deposition (ALD) process, a chemical vapor deposition (CVD) process, or a physical vapor deposition (PVD) process.

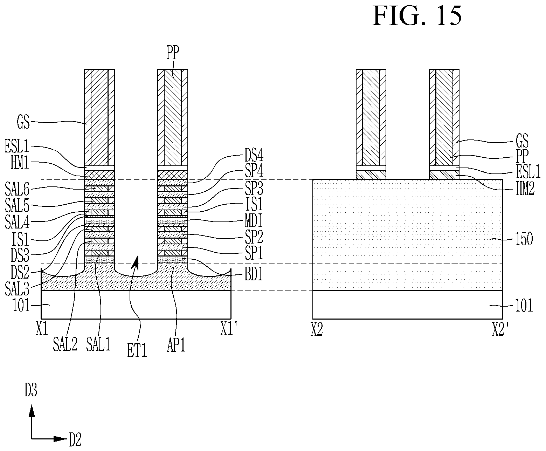

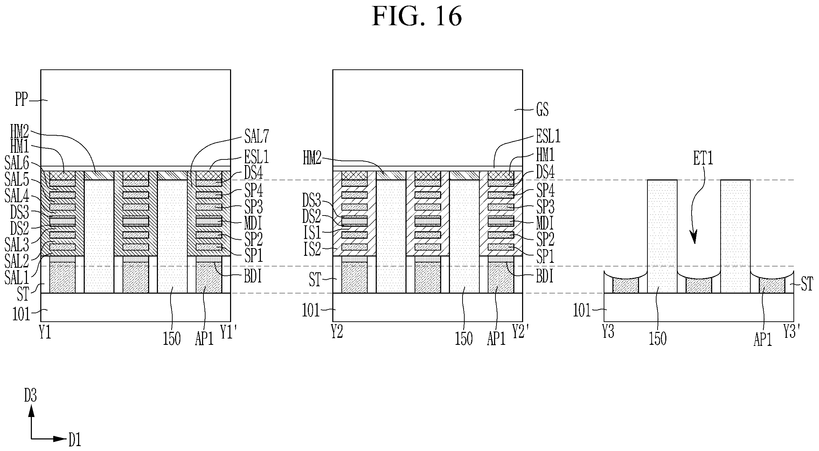

FIG. 15 shows cross-sectional views taken along lines X1-X1' and X2-X2' of FIG. 1 according to some implementations. FIG. 16 shows cross-sectional views taken along lines Y1-Y1', Y2-Y2', and Y3-Y3' of FIG. 1 according to some implementations.

In FIGS. 15 and 16, the first and second high-concentration sacrificial layers SCL1 and SCL2 exposed by the first recess ET1 may be selectively removed, and a lower insulation structure BDI and an intermediate insulation structure MDI may be formed in the removed space, respectively.

For example, the removal of the first and second high-concentration sacrificial layers SCL1 and SCL2 may be performed using a wet etching or dry etching method. At this time, the etchant used for etching the first and second high-concentration sacrificial layers SCL1 and SCL2 has a selectivity for the first and second high-concentration sacrificial layers SCL1 and SCL2 compared to the first to sixth low-concentration sacrificial layers SAL1 to SAL6, so that only the first and second high-concentration sacrificial layers SCL1 and SCL2 may be etched without etching the first to sixth low-concentration sacrificial layers SAL1 to SAL6.

Next, an insulating material may be filled in the space from which the first and second high-concentration sacrificial layers SCL1 and SCL2 have been removed to form a lower insulation structure BDI and an intermediate insulation structure MDI, respectively.

The insulating material may be deposited using an atomic layer deposition (ALD) process, a chemical vapor deposition (CVD) process, or a physical vapor deposition (PVD) process.

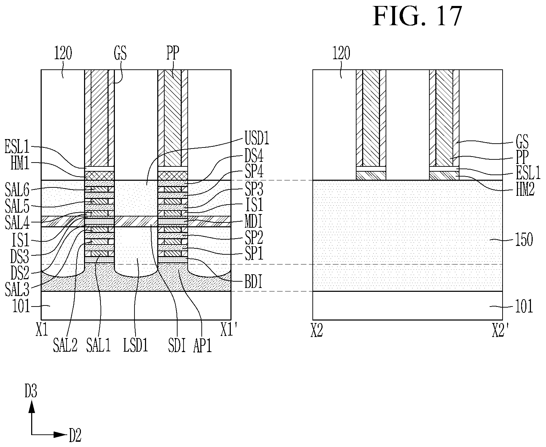

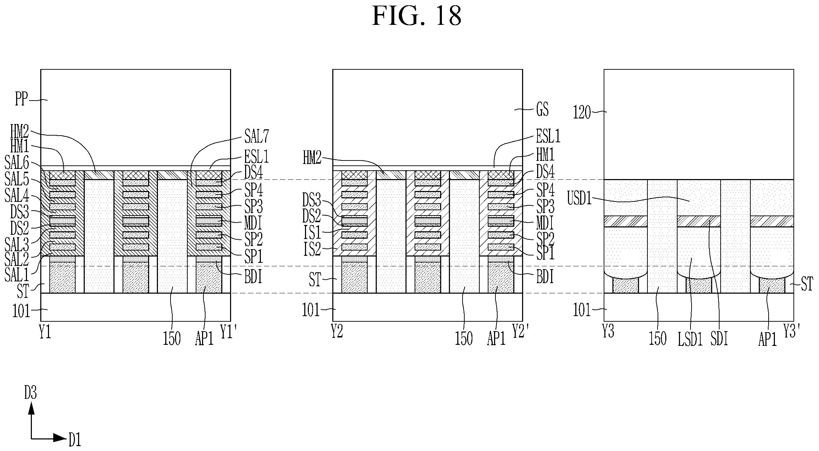

FIG. 17 shows cross-sectional views taken along lines X1-X1' and X2-X2' of FIG. 1 according to some implementations. FIG. 18 shows cross-sectional views taken along lines Y1-Y1', Y2-Y2', and Y3-Y3' of FIG. 1 according to some implementations.

In FIGS. 17 and 18, a lower source/drain pattern LSD1, a buried insulation layer SDI, and an upper source/drain pattern USD1 may be formed within the first recess ET1.

First, a lower source/drain pattern LSD1 may be formed within the first recess ET1. For example, a selective epitaxial growth (SEG) process may be performed using the side surface of the exposed lower channel pattern LCH1 and the upper surface of the active pattern AP1 as seed layers to form a lower source/drain pattern LSD1. The lower source/drain pattern LSD1 may be grown using the first and second semiconductor patterns SP1 and SP2 and the active pattern AP1 exposed by the first recess ET1 as seeds. For example, the selective epitaxial growth (SEG) process may include a chemical vapor deposition (CVD) process or a molecular beam epitaxy (MBE) process.

During the selective epitaxial growth (SEG) process, impurities may be implanted in-situ into the lower source/drain pattern LSD1. As another example, after the lower source/drain pattern LSD1 is formed, impurities may be implanted into the lower source/drain pattern LSD1. The lower source/drain pattern LSD1 may be doped to have a first conductivity type (e.g., N-type).

At this time, although not shown, in some embodiments, the side surface of the upper stacked pattern STP2 may be covered by a liner layer. In other words, the third and fourth semiconductor patterns SP3 and SP4 of the upper stacked pattern STP2 may not be exposed by the liner layer during the selective epitaxial growth (SEG) process of the lower source/drain pattern LSD1. Accordingly, a separate semiconductor layer may not be grown on the upper channel pattern UCH1 during the selective epitaxial growth (SEG) process.

First and second semiconductor patterns SP1 and SP2 interposed between a pair of lower source/drain patterns LSD1 may form a lower channel pattern LCH1. The lower channel pattern LCH1 and the lower source/drain pattern LSD1 may form a first active region AR1, which is a bottom tier of a three-dimensional device.

A buried insulation layer SDI may be formed within the first recess ET1. For example, the buried insulation layer SDI may fill the first recess ET1 to a level that covers the third dummy channel pattern DS3.

Next, the liner layer is removed so that both side surfaces of the upper channel pattern UCH1 may be exposed by the first recess ET1.

An upper source/drain pattern USD1 may be formed between the upper channel patterns UCH1 within the first recess ET1. For example, an upper source/drain pattern USD1 may be formed by performing a selective epitaxial growth (SEG) process using the side of the exposed upper stacked pattern STP2 as a seed layer. The upper source/drain pattern USD1 may be grown using the third and fourth semiconductor patterns SP3 and SP4 exposed by the first recess ET1 as seeds. For example, the selective epitaxial growth (SEG) process may include a chemical vapor deposition (CVD) process or a molecular beam epitaxy (MBE) process.

During the selective epitaxial growth (SEG) process, impurities may be implanted in-situ into the upper source/drain pattern USD1. As another example, after the upper source/drain pattern USD1 is formed, impurities may be implanted into the upper source/drain pattern USD1. The upper source/drain pattern USD1 may be doped to have a second conductivity type (e.g., P type) that is different from the first conductivity type (e.g., P type) of the lower source/drain pattern LSD1.

Third and fourth semiconductor patterns SP3 and SP4 interposed between a pair of upper source/drain patterns USD1 may form an upper channel pattern UCH1. The upper channel patterns UCH1 and the upper source/drain pattern USD1 may form a second active region AR2, which is a top tier of a three-dimensional device.

A second interlayer insulation layer 120 may be formed on the upper source/drain pattern USD1 and the partition wall pattern 150. For example, a second interlayer insulation layer 120 may be formed by depositing an insulating material on the upper source/drain pattern USD1 and the partition wall pattern 150, and the second interlayer insulation layer 120 may be planarized until the upper surface of the sacrificial pattern PP is exposed.

The insulating material may be deposited using an atomic layer deposition (ALD) process, a chemical vapor deposition (CVD) process, or a physical vapor deposition (PVD) process. The planarization of the second interlayer insulation layer 120 may be performed using an etch back or CMP (Chemical Mechanical Polishing) process. During the planarization process, the hardmask pattern may be completely removed. As a result, the upper surface of the second interlayer insulation layer 120 may be coplanar with the upper surface of the sacrificial pattern PP and the upper surfaces of the gate spacers GS.

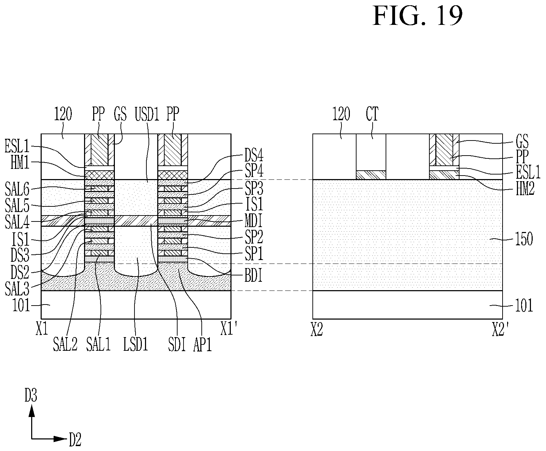

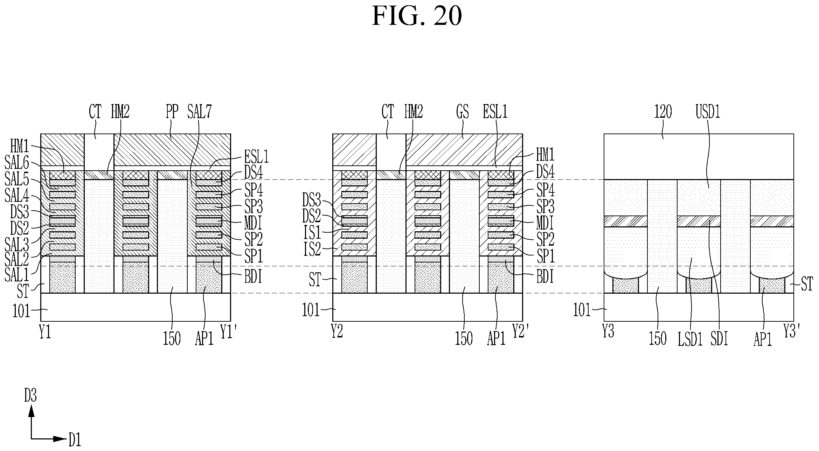

FIG. 19 shows cross-sectional views taken along lines X1-X1' and X2-X2' of FIG. 1 according to some implementations. FIG. 20 shows cross-sectional views taken along lines Y1-Y1', Y2-Y2', and Y3-Y3' of FIG. 1 according to some implementations.

In FIGS. 19 and 20, a gate cut pattern CT penetrating the sacrificial pattern PP may be formed. For example, the exposed sacrificial pattern PP may be selectively removed using a hardmask, and for example, a portion of the sacrificial pattern PP located on the partition wall pattern 150 may be removed.

The length of the removed sacrificial pattern PP in the first direction D1 may be substantially the same as the length of the partition wall pattern 150 in the first direction D1. The length of the removed sacrificial pattern PP in the second direction D2 may be substantially the same as the length of the first hardmask HM1 in the second direction D2. Accordingly, the connection of the main gate structure MGE may be cut by the gate cutting pattern CT on the partition wall pattern 150.

The removal of the sacrificial pattern PP may be accomplished by wet etching using an etchant that selectively etches polysilicon. By removing the sacrificial pattern PP, the second hardmask HM2 located on the partition wall pattern 150 may be exposed.

An insulating material may be filled in the space from which the sacrificial pattern PP has been removed to form a gate cutting pattern CT. The insulating material may be deposited using an atomic layer deposition (ALD) process, a chemical vapor deposition (CVD) process, or a physical vapor deposition (PVD) process.

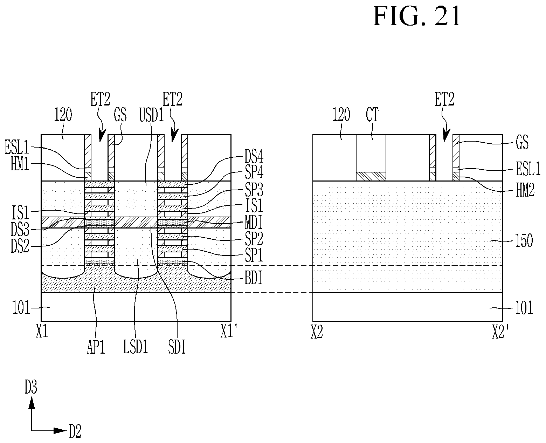

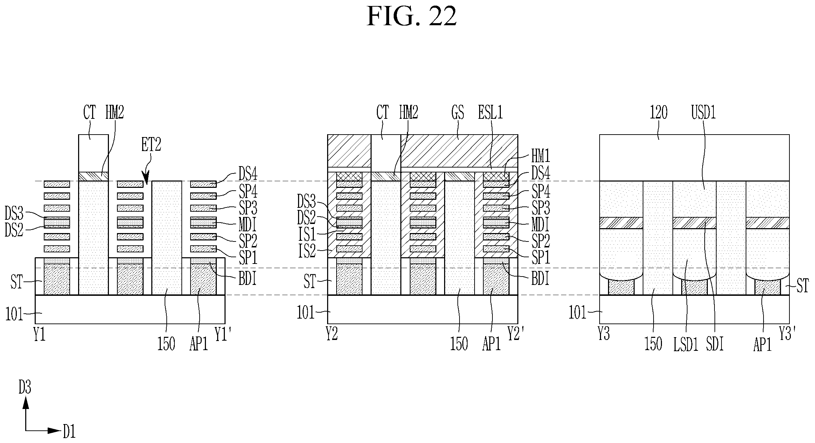

FIG. 21 shows cross-sectional views taken along lines X1-X1' and X2-X2' of FIG. 1 according to some implementations. FIG. 22 shows cross-sectional views taken along lines Y1-Y1', Y2-Y2', and Y3-Y3' of FIG. 1 according to some implementations.

In FIGS. 21 and 22, the exposed sacrificial pattern PP and the first and second hardmasks HM1 and HM2 may be selectively removed, and a second recess ET2 may be formed. The removal of the sacrificial pattern PP may be accomplished by wet etching using an etchant that selectively etches polysilicon. By removing the sacrificial pattern PP and the first and second hardmasks HM1 and HM2, the first to seventh sacrificial layers SAL1 to SAL7 may be exposed.

By performing an etching process that selectively etches the first to seventh sacrificial layers SAL1 to SAL7 exposed by the second recess ET2, only the first to seventh sacrificial layers SAL1 to SAL7 may be removed while leaving the first to fourth semiconductor patterns SP1 to SP4 and the second to fourth dummy channel patterns DS2 to DS4 intact. The etching process may have a high etching rate for silicon germanium. For example, the etching process may have a high etching rate for silicon germanium having a germanium concentration greater than about 10 at%.

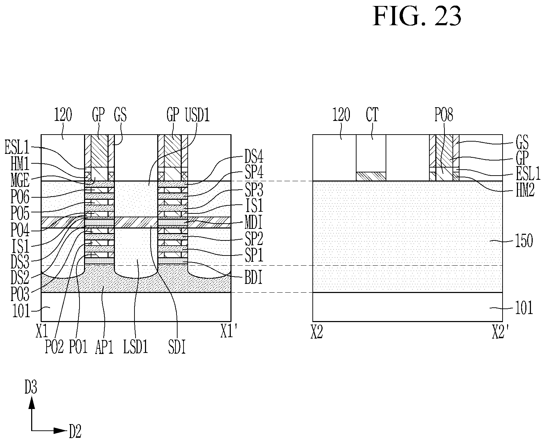

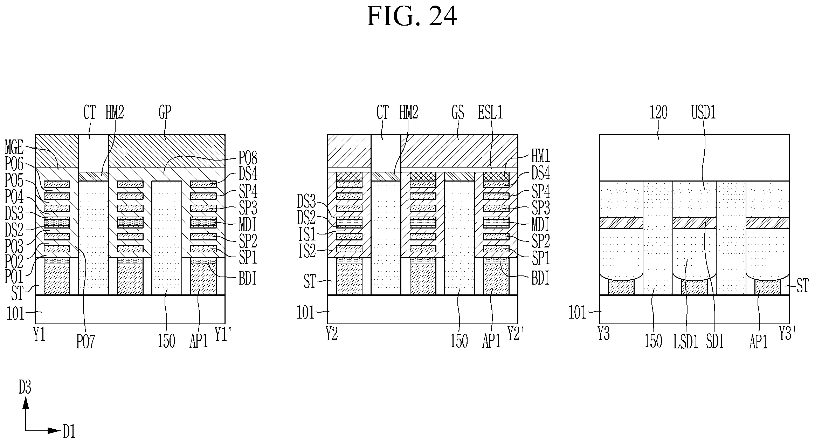

FIG. 23 shows cross-sectional views taken along lines X1-X1' and X2-X2' of FIG. 1 according to some implementations. FIG. 24 shows cross-sectional views taken along lines Y1-Y1', Y2-Y2', and Y3-Y3' of FIG. 1 according to some implementations.

In FIGS. 23 and 24, a gate pattern GE may be formed within an area where the sacrificial pattern PP and the first to seventh sacrificial layers SAL1 to SAL7 are removed.

First, in some implementations, a gate insulation layer may be conformally formed within an area where the sacrificial pattern PP and the first to seventh sacrificial layers SAL1 to SAL7 are removed.

A gate pattern GE may be formed on the gate insulation layer. The formation of the gate pattern GE may be performed by forming a lower gate structure LGE including first to third sub-gate portions P01 to P03 between first and second semiconductor patterns SP1 and SP2, forming an upper gate structure UGE including fourth to sixth sub-gate portions P04 to P06 between third and fourth semiconductor patterns SP3 and SP4, and forming a main gate structure MGE in an area from which the sacrificial pattern PP is removed.

The gate pattern GE may be recessed to reduce its height. A gate capping pattern GP may be formed on a recessed gate pattern GE. A planarization process may be performed on the gate capping pattern GP so that the upper surface of the gate capping pattern GP is coplanar with the upper surface of the second interlayer insulation layer 120.

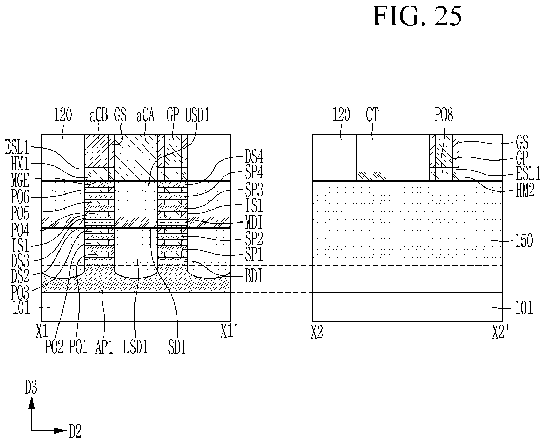

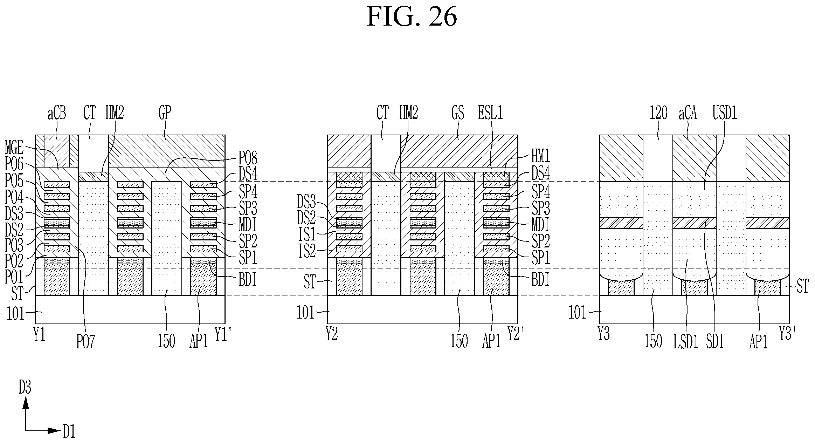

FIG. 25 shows cross-sectional views taken along lines X1-X1' and X2-X2' of FIG. 1 according to some implementations. FIG. 26 shows cross-sectional views taken along lines Y1-Y1', Y2-Y2', and Y3-Y3' of FIG. 1 according to some implementations.

In FIGS. 25 and 26, an upper source/drain contact aCA connected to an upper source/drain pattern USD1 is formed, and an upper gate contact aCB connected to a main gate structure MGE of a gate pattern GE is formed. For example, a hardmask pattern is formed on a second interlayer insulation layer 120, and the second interlayer insulation layer 120 is patterned using the hardmask pattern as an etching mask, thereby penetrating the second interlayer insulation layer 120 in a third direction D3 to form a first contact hole on the upper surface of the upper source/drain pattern USD1. For example, patterning may utilize dry etching.

Additionally, a second contact hole is formed that penetrates the gate capping pattern GP in the third direction D3 to expose the upper surface of the main gate structure MGE of the gate pattern GE.

A metal is filled into the first and second contact holes to form an upper source/drain contact aCA connected to the upper source/drain pattern USD1 in the first contact hole, and an upper gate contact aCB connected to the main gate structure MGE of the gate pattern GE is formed in the second contact hole.

In the above, the case where the upper source/drain contact aCA and the upper gate contact aCB are formed in separate processes has been described, but the present disclosure is not limited thereto, and the upper source/drain contact aCA and the upper gate contact aCB may be formed simultaneously, or the upper gate contact aCB may be formed first and then the upper source/drain contact aCA may be formed.

In some implementations, a first upper interlayer insulation layer may be formed on the upper surface of the second interlayer insulation layer 120 and a first upper metal layer electrically connected to the upper source/drain contact aCA and the upper gate contact aCB.

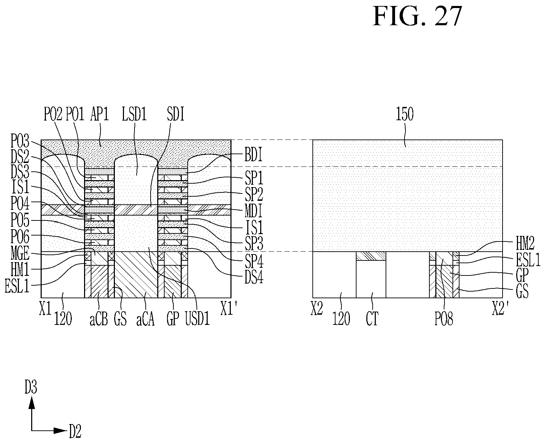

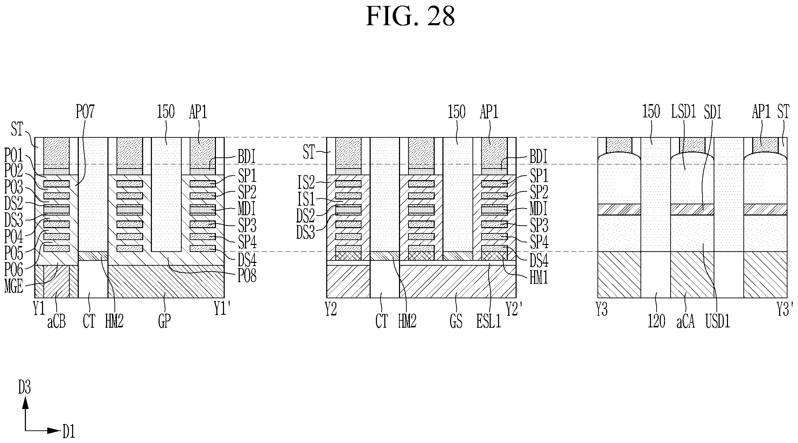

FIG. 27 shows cross-sectional views taken along lines X1-X1' and X2-X2' of FIG. 1 according to some implementations. FIG. 28 shows cross-sectional views taken along lines Y1-Y1', Y2-Y2', and Y3-Y3' of FIG. 1 according to some implementations.

In FIGS. 27 and 28, the lower substrate 101 is removed.

First, semiconductor devices may be rotated.

For example, in some implementations, the rotated semiconductor device may be located on a carrier substrate. At this time, the upper surface of the semiconductor device may be located to face the carrier substrate and then attached to the carrier substrate. That is, a first upper interlayer insulation layer located on the upper surface of the semiconductor device may be attached on the carrier substrate. An adhesive material may be placed between the first upper interlayer insulation layer and the carrier substrate.

The carrier substrate may have substantially the same area as the semiconductor device or may have a larger area. The carrier substrate may be, for example, a semiconductor wafer, a ceramic substrate, or a glass substrate. The adhesive member may be in the form of a film.

The adhesive member may include a base film and an adhesive layer attached to both sides of the base film. The base film may be, for example, a polyethylene-based film such as polyethylene terephthalate (PET) or polyethylene-2,6-naphthalenedicarboxylate (PEN) or a polyolefin-based film. The base film may be formed by coating a polyethylene film or a polyolefin film with silicone or TEFLON (polytetrafluoroethylene). The adhesive layer may be made of, for example, an acrylic polymer resin, an epoxy resin, or a mixture thereof.

Next, an etching process may be performed to remove the lower substrate 101. The etching process may be performed by, for example, a wet etching method, but is not limited thereto.

As the lower substrate 101 is removed, the lower surface of the partition wall pattern 150 may be exposed. Accordingly, by utilizing the exposed partition wall pattern 150, a lower source/drain contact bCA and a lower gate contact bCB may be formed by self-alignment without an additional structure such as a place holder.

In addition, since the gate inner spacer GIS extends in the first direction D1 to one partition wall pattern 150 and another partition wall pattern 150 adjacent thereto in the first direction D1, the gate inner spacer GIS is located on the entire surface of the gate pattern GE in contact with the lower source/drain pattern LSD1 and the upper source/drain pattern USD1, and the lower portion of the gate pattern GE is protected by the lower insulation structure BDI, the gate pattern GE may be prevented from being damaged when the lower source/drain contact bCA is formed.

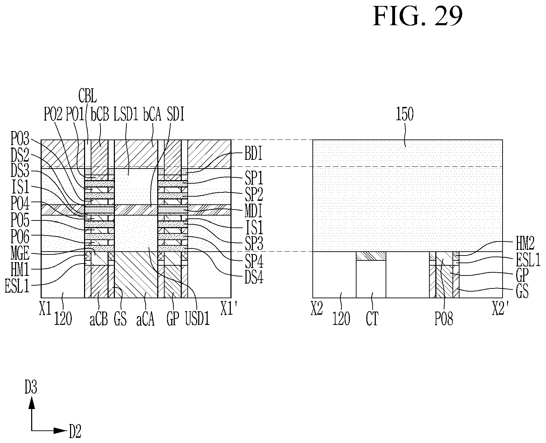

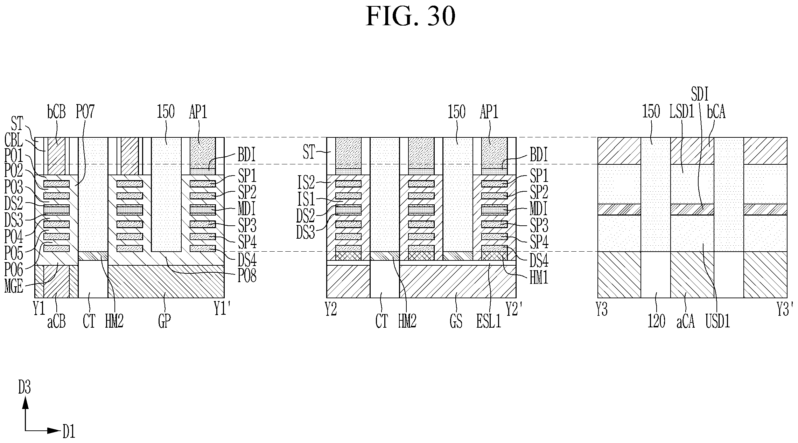

FIG. 29 shows cross-sectional views taken along lines X1-X1' and X2-X2' of FIG. 1 according to some implementations. FIG. 30 shows cross-sectional views taken along lines Y1-Y1', Y2-Y2', and Y3-Y3' of FIG. 1 according to some implementations.

In FIGS. 29 and 30, a lower source/drain contact bCA connected to a lower source/drain pattern LSD1 is formed, and a lower gate contact bCB connected to a lower gate structure LGE of a gate pattern GE is formed. For example, a patterning process may be performed to remove a portion of the active pattern AP1 to form a third contact hole exposing the lower source/drain pattern LSD1. At this time, the third contact hole may penetrate the active pattern AP1. In other words, the side of the third contact hole may be surrounded by the active pattern AP1.

Next, the third contact hole is filled to form a lower source/drain contact bCA that is electrically connected to the lower source/drain pattern LSD1.

Next, a patterning process may be performed to remove a portion of the active pattern AP1 to form a fourth contact hole exposing the first sub-gate portion P01 of the gate pattern GE. At this time, the fourth contact hole may penetrate the active pattern AP1. In other words, the side of the fourth contact hole may be surrounded by the active pattern AP1.

Next, an insulation liner CBL is conformally applied to the side of the fourth contact hole, and then the fourth contact hole is filled to form a lower gate contact bCB electrically connected to the first sub-gate portion P01 of the gate pattern GE.

In the above, the case where the lower source/drain contact bCA and the lower gate contact bCB are formed in separate processes has been described, but the present disclosure is not limited thereto, and the lower source/drain contact bCA and the lower gate contact bCB may be formed simultaneously, or the lower gate contact bCB may be formed first and then the lower source/drain contact bCA may be formed.

In some implementations, a first lower interlayer insulation layer may be formed on the lower surface of the active pattern AP1 including a device isolation layer ST and a first lower metal layer electrically connected to a lower source/drain contact bCA and a lower gate contact bCB.

While this disclosure contains many specific implementation details, these should not be construed as limitations on the scope of what may be claimed, equivalents thereof, as well as claims to be described later. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. A semiconductor device, comprising:
active patterns spaced apart from one another in a first direction and extending in a second direction different from the first direction;
a lower channel pattern and a lower source/drain pattern on the active patterns, wherein the lower channel pattern and the lower source/drain pattern are alternately arranged in the second direction;
an upper channel pattern on the lower channel pattern;
an upper source/drain pattern on the lower source/drain pattern;
a gate pattern on the active patterns and on the lower channel pattern and the upper channel pattern; and
a gate inner spacer located on the gate pattern, and between the lower source/drain pattern and the upper source/drain pattern;
wherein the gate inner spacer has an overlapping portion that overlaps with the upper channel pattern and the lower channel pattern in a third direction that is perpendicular to the first direction and the second direction, and a non-overlapping portion that is free from overlapping with the upper channel pattern and the lower channel pattern in the third direction.

2. The semiconductor device of claim 1,
wherein the lower channel pattern and the upper channel pattern include a plurality of semiconductor patterns stacked and spaced apart from each other in the third direction,
wherein the overlapping portion of the gate inner spacer is located between adjacent ones of the plurality of semiconductor patterns, and
wherein the non-overlapping portion of the gate inner spacer is located on sides of the semiconductor patterns in the first direction, and extends in the third direction from a first semiconductor pattern of the plurality of semiconductor patterns located at a lowermost end of the non-overlapping portion to a second semiconductor pattern of the plurality of semiconductor patterns located at an uppermost end of the non-overlapping portion.

3. The semiconductor device of claim 2,
wherein the semiconductor device comprises:
a device separation layer located on sides of the active pattern in the first direction;
a first hardmask on the upper channel pattern; and
an etch stop layer on the first hardmask,
wherein the non-overlapping portion of the gate inner spacer extends from an upper surface of the device separation layer to a lower surface of the etch stop layer in the third direction.

4. The semiconductor device of claim 2 or claim 3, further comprising a partition wall pattern comprising a plurality of partition walls spaced apart from one another in the first direction, extending in the second direction, and alternately arranged with the active patterns in the first direction, and
wherein the gate inner spacer extends in the first direction from a first partition wall to an adjacent partition wall in the first direction.

5. The semiconductor device of claim 4,
wherein the overlapping portion of the gate inner spacer is between the partition wall pattern and another partition wall pattern adjacent to the partition wall pattern in the first direction,
wherein the non-overlapping portion of the gate inner spacer is between the overlapping portion and the partition wall pattern,
wherein the overlapping portion is spaced apart from the partition wall pattern, and
wherein the non-overlapping portion contacts the partition wall pattern.

6. The semiconductor device of any of claims 2-5, wherein the gate pattern comprises:
a lower gate structure on the active patterns, wherein the lower gate structure includes a plurality of lower sub-gate portions between adjacent ones of the semiconductor patterns;
an upper gate structure on the lower gate structure, wherein the upper gate structure includes a plurality of upper sub-gate portions located between adjacent ones of the semiconductor patterns;
a main gate structure on the upper gate structure; and
a sub-gate connection portion on sides of the lower sub-gate portions in the first direction,
wherein the sub-gate connection portion extends in the third direction from one of the lower sub-gate portions located at an uppermost end of the lower sub-gate portions to one of the upper sub-gate portions located at an uppermost end of the upper sub-gate portions, and
wherein the sub-gate connection portion is free from overlapping the upper channel pattern and the lower channel pattern in the third direction.

7. The semiconductor device of claim 6,
wherein the semiconductor device further comprises a partition wall pattern comprising a plurality of partition walls spaced apart from one another in the first direction, extending in the second direction, and alternately arranged with the active pattern in the first direction, and
wherein the gate pattern extends in the first direction from a first partition wall to another partition wall adjacent to the first partition wall pattern in the first direction.

8. The semiconductor device of claim 7,
wherein the lower sub-gate portions and the upper sub-gate portions of the gate pattern are located between the first partition wall and the another partition wall, and the sub-gate connection portion is located between the lower sub-gate portions and the upper sub-gate portions and the first partition wall and the another partition wall,
wherein the lower sub-gate portions and the upper sub-gate portions do not contact the partition wall pattern, and
wherein the sub-gate connection portion contacts the partition wall pattern.

9. The semiconductor device of any of claims 6-8, wherein the semiconductor device further comprises:
a lower insulation structure between the active patterns and the lower gate structure; and
an intermediate insulation structure between the lower gate structure and the upper gate structure.

10. The semiconductor device of claim 9,
wherein the lower insulation structure and the intermediate insulation structure overlaps with the lower channel pattern, the upper channel pattern, the upper gate structure, and the lower gate structure of the gate pattern, and the overlapping portion of the gate inner spacer in the third direction,
wherein the lower insulation structure and the intermediate insulation structure are free from overlapping with the sub-gate connection portion of the gate pattern and the non-overlapping portion of the gate inner spacer in the third direction,
wherein a length of the lower insulation structure in the second direction is greater than a length of the intermediate insulation structure in the second direction, and
wherein a length of the lower sub-gate portions of the lower gate structure in the second direction is greater than a length of the upper sub-gate portions of the upper gate structure in the second direction.

11. The semiconductor device of any preceding claim, wherein the semiconductor device further comprises:
a lower source/drain contact under the lower source/drain pattern and connected to the lower source/drain pattern; and
a partition wall pattern comprising partition walls spaced apart from one another in the first direction, extending across the gate pattern in the second direction, and alternately disposed with the active patterns in the first direction;
wherein, in a third direction perpendicular to the first direction and the second direction, the partition walls extend from a level lower than an upper surface of the lower source/drain contact to a level lower than an upper surface of the gate pattern.

12. The semiconductor device of claim 11, wherein the gate pattern comprises:
a lower gate structure on the active pattern and including a plurality of lower sub-gate portions between semiconductor patterns included in the lower channel pattern;
an upper gate structure on the lower gate structure and including a plurality of upper sub-gate portions between semiconductor patterns included in the upper channel pattern; and
a main gate structure on the upper gate structure.

13. The semiconductor device of claim 12,
wherein the partition walls are located between one of the lower gate structure and the upper gate structure, and another of the lower gate structure and the upper gate structure adjacent to the one of the lower gate structure and the upper gate structure in the first direction,
wherein at least one of the lower sub-gate portions, the upper sub-gate portions, and a sub-gate connection portion located on sides of the lower sub-gate portions and the upper sub-gate portions is separated by another one of the lower sub-gate portions, the upper sub-gate portions adjacent to the second direction and the sub-gate connection portion, and the partition wall pattern.

14. The semiconductor device of claim 13, wherein the gate pattern comprises:
a main gate connection portion on any one of the partition walls,
wherein the main gate structure includes a first main gate structure and a second main gate structure spaced apart from one another in the first direction with one of the partition walls interposed therebetween,
wherein the first main gate structure and the second main gate structure are connected by the main gate connection portion,
wherein the semiconductor device comprises:
a second hardmask on one of the partition walls, and a gate cutting pattern on the second hardmask,
wherein one main gate structure and another main gate structure, which are spaced apart in the first direction with one of the partition walls interposed therebetween, are separated by the gate cutting pattern,
wherein the lower source/drain pattern comprises a plurality of lower source/drain patterns,
wherein the partition walls are located between a first lower source/drain pattern of the plurality of lower source/drain patterns and a second lower source/drain pattern of the plurality of lower source/drain patterns adjacent to the first lower source/drain pattern in the first direction,
wherein the upper source/drain pattern comprises a plurality of upper source/drain patterns,
wherein the partition walls are between a first upper source/drain pattern of the plurality of upper source/drain patterns and a second upper source/drain pattern of the plurality of upper source/drain patterns adjacent to the first upper source/drain pattern in the first direction,
wherein the lower gate structure comprises a plurality of lower gate structures,
wherein the partition walls are between a first lower gate structure of the plurality of lower gate structures and a second lower gate structure of the plurality of lower gate structures adjacent to the first lower gate structure in the first direction,
wherein the upper gate structure comprises a plurality of upper gate structures,
wherein the partition walls are between a first upper gate structure of the upper gate structures and a second upper gate structure of the plurality upper gate structures adjacent to the first upper gate structure in the first direction,
wherein the semiconductor device further comprises a lower gate contact located under the gate pattern and connected to the gate pattern,
wherein the lower source/drain contact comprises a plurality of lower source/drain contacts,
wherein the partition walls are between a first lower source/drain contact of the plurality of lower source/drain contacts and a second lower source/drain contact of the plurality lower source/drain contacts adjacent to the first lower source/drain contact in the first direction,
wherein the lower gate contact comprises a plurality of lower gate contacts, and
wherein the partition walls are between a first lower gate contact of the plurality of lower gate contacts and a second lower gate contact of the plurality lower gate contacts adjacent to the first lower gate contact in the first direction.

15. The semiconductor device of any preceding claim, wherein the semiconductor device further comprises:
a gate inner spacer between gates of the gate pattern, the lower source/drain pattern, and the upper source/drain pattern, and having an overlapping portion that is overlapped with the upper channel pattern and the lower channel pattern in a third direction perpendicular to the first direction and the second direction, and a non-overlapping portion that is free from overlapping with the upper channel pattern and the lower channel pattern in the third direction; and
a partition wall pattern comprising a plurality of partition walls spaced apart from one another in the first direction, extending in the second direction, and alternately arranged with the active pattern in the first direction;
wherein side surfaces of the lower source/drain pattern in the first direction and the upper source/drain pattern are surrounded by the partition wall pattern, and
wherein side surfaces of the lower source/drain pattern in the second direction and the upper source/drain pattern are surrounded by the overlapping portion and the non-overlapping portion of the gate inner spacer.
